# EUROPEAN PATENT APPLICATION

(11) **EP 4 766 068 A1**
(43) Date of publication of application: **24.06.2026**
(21) Application number: 25195676.9
(22) Date of filing: 13.08.2025
(51) Int. Cl.: H10B 43/27, H10B 43/40, H10B 43/50, G11C 16/04, H10B 80/00

(54) **SEMICONDUCTOR DEVICES AND DATA STORAGE SYSTEMS INCLUDING THE SAME**

(30) Priority: 23.12.2024 KR 20240193915
(71) Applicant: Samsung Electronics Co., Ltd., Suwon-si, Gyeonggi-do 16677 (KR)
(72) Inventor: LEE, Gilsung, 16677 Suwon-si, Gyeonggi-do (KR); KWAK, Solmi, 16677 Suwon-si, Gyeonggi-do (KR); SHIM, Jaejoo, 16677 Suwon-si, Gyeonggi-do (KR); LEE, Seungjun, 16677 Suwon-si, Gyeonggi-do (KR); JANG, Hanbyeol, 16677 Suwon-si, Gyeonggi-do (KR); CHUNG, Soochan, 16677 Suwon-si, Gyeonggi-do (KR); HWANG, Hyunyoung, 16677 Suwon-si, Gyeonggi-do (KR)
(74) Representative: Kuhnen & Wacker Patent- und Rechtsanwaltsbüro PartG mbB

(57) **Abstract**

A semiconductor device (100) includes: a first substrate structure (S1) including a substrate (201) and circuit elements (220) and a second substrate structure (S2) on the first substrate structure (S1), wherein the second substrate structure (S2) includes gate electrodes (130) stacked in a first direction (Z), interlayer insulating layers (120) alternately stacked with the gate electrodes (130), channel structures (CH) that extend into the gate electrodes (130) and respectively include a channel layer (140) and a channel dielectric layer (145) on a side surface of the channel layer (140), and a source structure (160) that is on the channel structures (CH) and includes a horizontal region (162) and a contact region (164) extending from the horizontal region (162) and contacting the channel layer (140), where the contact region (164) extend into a portion of the channel dielectric layer (145) of each of the channel structures (CH), and a lower surface of the contact region (164) is in contact with the channel structures (CH) and the interlayer insulating layers (120).

## Description

### TECHNICAL FIELD

The present disclosure relates to semiconductor devices and data storage systems including the same.

### BACKGROUND

In a data storage system including data storage, a semiconductor device capable of storing a large amount of data may be desirable. Accordingly, a method for increasing the data storage capacity of a semiconductor device has been researched. For example, as one method for increasing the data storage capacity of a semiconductor device, a semiconductor device including memory cells arranged three-dimensionally instead of two-dimensionally arranged memory cells has been proposed.

### SUMMARY

An aspect of the present disclosure is to provide a semiconductor device having improved reliability and mass productivity.

An aspect of the present disclosure is to provide a data storage system including a semiconductor device having improved reliability and mass productivity.

A semiconductor device according to example embodiments includes: a first substrate structure that includes a substrate, circuit elements on the substrate, a first interconnection structure on the circuit elements, and first bonding pads on the first interconnection structure, and a second substrate structure on the first substrate structure, where the second substrate structure includes: gate electrodes that are spaced apart from each other and are stacked in a first direction that is perpendicular to an upper surface of the substrate, interlayer insulating layers alternately stacked with the gate electrodes, channel structures that extend into the gate electrodes and in the first direction and respectively include a channel layer and a channel dielectric layer on a side surface of the channel layer, an upper insulating layer that is on upper ends of the channel structures and the interlayer insulating layers, a source structure on the upper insulating layer, the source structure including a horizontal region that extends in a second direction that is parallel to the upper surface of the first substrate structure and a contact region that extends into a portion of the upper insulating layer and each of the channel structures, extends from the horizontal region in the first direction, and contacts the channel layer of each of the channel structures, a second interconnection structure that is on the gate electrodes and includes bit lines electrically connected to respective ones of the channel structures, and second bonding pads that are on the second interconnection structure and are electrically connected to the first bonding pads, where a portion of an upper surface of each of the channel structures is in contact with the upper insulating layer.

A semiconductor device according to example embodiments includes: a first substrate structure including a substrate and circuit elements on the substrate; and a second substrate structure on the first substrate structure, wherein the second substrate structure includes: a first substrate structure that includes a substrate and circuit elements on the substrate, and a second substrate structure on the first substrate structure, where the second substrate structure includes: gate electrodes that are spaced apart from each other and are stacked in a first direction that is perpendicular to an upper surface of the substrate, interlayer insulating layers that are alternately stacked with the gate electrodes, channel structures that extend into the gate electrodes and in the first direction and respectively include a channel layer and a channel dielectric layer on a side surface of the channel layer, and a source structure that is on the channel structures and includes a horizontal region that extends in a second direction that is parallel to the upper surface of the substrate and a contact region that extends from the horizontal region in the first direction and contacts the channel layer, where the contact region extends into a portion of the channel dielectric layer of each of the channel structures, and where a lower surface of the contact region is in contact with the channel structures and the interlayer insulating layers.

A data storage system according to example embodiments includes: a semiconductor storage device including a first substrate structure including a substrate and circuit elements on the substrate, the semiconductor storage device including a second substrate structure including gate electrodes and input/output pads electrically connected to respective ones of the circuit elements, and a controller electrically connected to the semiconductor storage device through the input/output pads and configured to control the semiconductor storage device, where the second substrate structure includes: gate electrodes spaced that are spaced apart from each other and stacked in a first direction that is perpendicular to an upper surface of the substrate, channel structures that extend into the gate electrodes and in the first direction, the channel structures respectively including a channel layer and a channel dielectric layer on a side surface of the channel layer, and a source structure that is on the channel structures and includes a horizontal region that extends in a second direction that is parallel to the upper surface of the substrate and a contact region that extends from the horizontal region in the first direction and contacts the channel layer, where the contact region is in contact with a first portion of the side surface of the channel layer and is not in contact with a second portion of the side surface of the channel layer, in an upper region of each of the channel structures.

A source structure may be connected to a channel layer through a contact region penetrating through or extending into a portion of the channel structure, thereby providing a semiconductor device having improved reliability and mass producibility and a data storage system including the same.

Advantages and effects of the present application are not limited to the foregoing content and may be more easily understood in the process of describing a specific example embodiment of the present disclosure.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic plan view of a semiconductor device according to example embodiments;
FIG. 2 is a schematic cross-sectional view of a semiconductor device according to example embodiments;
FIG. 3 is a partially enlarged view of a semiconductor device according to example embodiments;
FIGS. 4A, 4B, and 4C are schematic partial enlarged views of a semiconductor device according to example embodiments;
FIGS. 5A, 5B, 5C, and 5D are schematic plan views of a semiconductor device according to example embodiments;
FIGS. 6A and 6B are a schematic cross-sectional view and a partially enlarged view, respectively, of a semiconductor device according to example embodiments;
FIG. 7 is a schematic cross-sectional view of a semiconductor device according to example embodiments;
FIG. 8 is a schematic cross-sectional view of a semiconductor device according to example embodiments;
FIGS. 9A and 9B are a schematic plan view and a cross-sectional view, respectively, of a semiconductor device according to example embodiments;
FIGS. 10A, 10B, 10C, and 10D are schematic cross-sectional views and partially enlarged views of a semiconductor device according to example embodiments;
FIGS. 11A, 11B, 11C, 11D, 11E, and 11F are schematic cross-sectional views illustrating a method of manufacturing a semiconductor device according to example embodiments;
FIG. 12 is a view schematically illustrating a data storage system including a semiconductor device according to example embodiments;
FIG. 13 is a perspective view schematically illustrating a data storage system including a semiconductor device according to example embodiments; and
FIG. 14 is a cross-sectional view schematically illustrating a semiconductor package according to example embodiments.

### DETAILED DESCRIPTION

Hereinafter, example embodiments of the present disclosure will be described with reference to the accompanying drawings. Hereinafter, the terms 'above,' 'upper portion,' 'upper surface,' 'below', 'lower portion,' 'lower surface,' 'side surface,' and the like, may be understood as being indicated based on the accompanying drawing, except that they are indicated by drawing references and referred to separately.

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct or indirect physical and/or electrical connection. The term "exposed" may be used to define a relationship between particular layers or surfaces, but it does not require the layer or surface to be free of other elements or layers thereon in the completed device. Components or layers described with reference to "overlap" in a particular direction may be at least partially obstructed by one another when viewed along a line extending in the particular direction or in a plane perpendicular to the particular direction. The terms "first," "second," etc. may be used herein to merely distinguish one component, element, etc., from another.

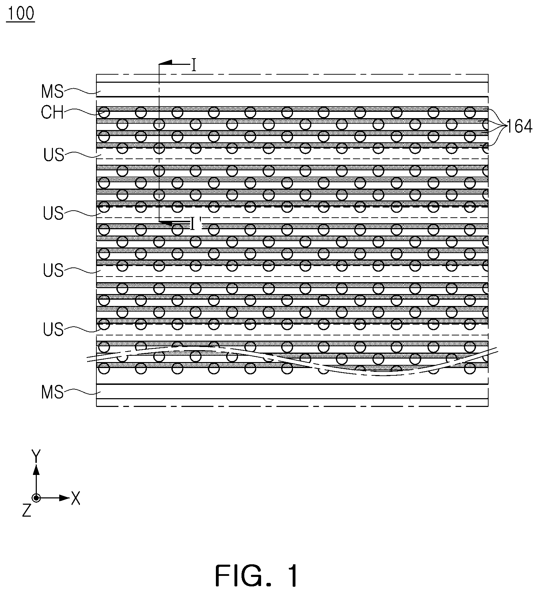

FIG. 1 is a schematic plan view of a semiconductor device according to example embodiments.

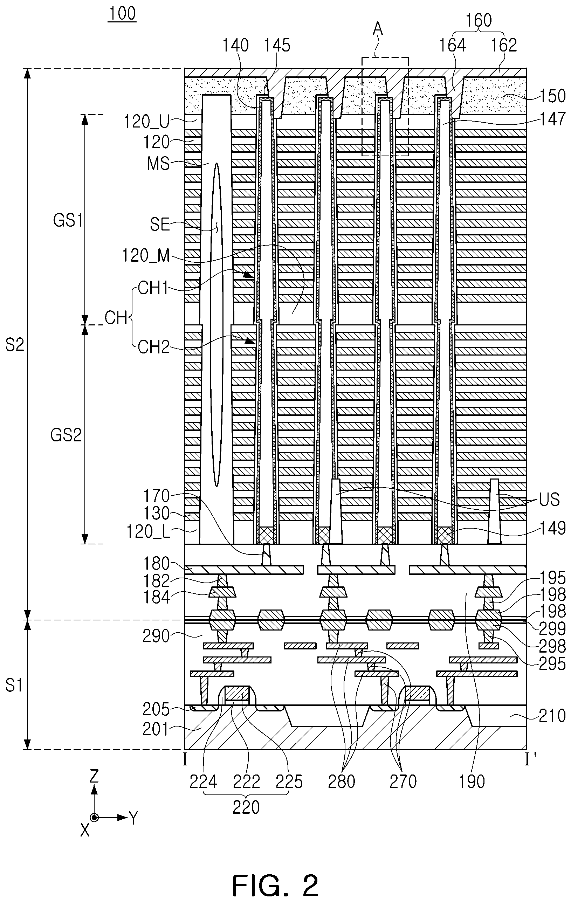

FIG. 2 is a schematic cross-sectional view of a semiconductor device according to example embodiments. FIG. 2 is a cross-sectional view taken along cutting line I-I' of FIG. 1.

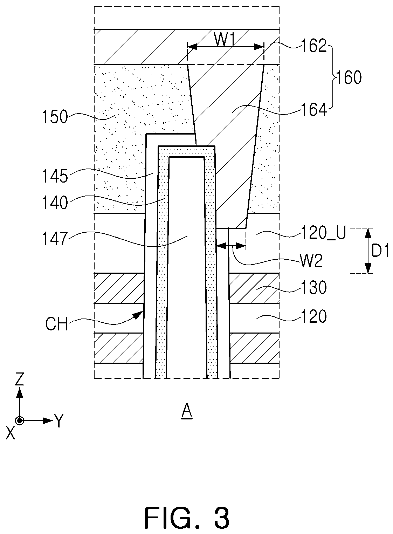

FIG. 3 is a partially enlarged view of the semiconductor device according to example embodiments. FIG. 3 is an enlarged view of region 'A' of FIG. 2.

Referring to FIGS. 1 to 3, a semiconductor device 100 includes first and second substrate structures S1 and S2 that are bonded to each other and are vertically (e.g., in the Z-direction) arranged. The first substrate structure S1 may include a peripheral circuit region, and the second substrate structure S2 may include a memory cell region. In some example embodiments, the second semiconductor structure S2 may be disposed below the first semiconductor structure S1. FIG. 1 illustrates a planar arrangement of some components of the second semiconductor structure S2.

The first substrate structure S1 may include a substrate 201, source/drain regions 205 and element isolation layers 210 within the substrate 201, circuit elements 220 disposed on the substrate 201, a peripheral region insulating layer 290, circuit contact plugs 270, circuit interconnection lines 280, first bonding vias 295, first bonding pads 298, and a first bonding insulating layer 299.

The substrate 201 may have an upper surface extending in an X-direction and a Y-direction. An active region may be defined in the substrate 201 by the element isolation layers 210. The source/drain regions 205 including impurities may be disposed in a portion of the active region. The substrate 201 may include a semiconductor material, such as a group IV semiconductor, a group III-V compound semiconductor, or a group II-VI compound semiconductor. The substrate 201 may be provided as a bulk wafer or an epitaxial layer.

The circuit elements 220 may include planar transistors. Each of the circuit elements 220 may include a circuit gate dielectric layer 222, a spacer layer 224, and a circuit gate electrode 225. The source/drain regions 205 may be disposed as source/drain regions within the substrate 201 on both sides of the circuit gate electrode 225.

The peripheral region insulating layer 290 may be disposed to cover or at least partially overlap the circuit elements 220 on an upper surface of the substrate 201. The peripheral region insulating layer 290 may include a plurality of insulating layers formed in different process operations. The peripheral region insulating layer 290 may be formed of an insulating material.

The circuit contact plugs 270 and the circuit interconnection lines 280 may be included in a first interconnection structure electrically connected to the circuit elements 220 and the source/drain regions 205. The circuit contact plugs 270 may have a cylindrical shape, and the circuit interconnection lines 280 may have a line or linear shape. An electrical signal may be applied to the circuit elements 220 by the circuit contact plugs 270 and the circuit interconnection lines 280. In a region not illustrated, the circuit contact plugs 270 may also be connected to the circuit gate electrode 225. The circuit interconnection lines 280 may be connected to the circuit contact plugs 270 and may be disposed in a plurality of layers. The circuit contact plugs 270 and the circuit interconnection lines 280 may include a conductive material, for example, tungsten (W), copper (Cu), and aluminum (Al), and each of these components may further include a diffusion barrier layer. In example embodiments, the number of layers of the circuit contact plugs 270 and the circuit interconnection lines 280 may be variously changed.

The first bonding vias 295, the first bonding pads 298, and the first bonding insulating layer 299 may be included in a first bonding structure and may be disposed on uppermost circuit interconnection lines 280. The first bonding vias 295 may have a cylindrical shape, and the first bonding pads 298 may have a pad shape having a circular shape on a plane or a relatively short line or linear shape. Upper surfaces of the first bonding pads 298 may form a portion of the upper surface of the first substrate structure S1. The first bonding vias 295 and the first bonding pads 298 may provide electrical connection paths with the second semiconductor structure S2. In example embodiments, some of the first bonding pads 298 may not be connected to the circuit interconnection lines 280 and may be disposed only for bonding. The first bonding vias 295 and the first bonding pads 298 may include a conductive material, for example, copper (Cu).

The first bonding insulating layer 299 may be disposed on an upper surface of the peripheral region insulating layer 290 at a predetermined thickness. The first bonding insulating layer 299 may be a layer for dielectric-to-dielectric bonding with a second bonding insulating layer 199 of the second semiconductor structure S2. The first bonding insulating layer 299 may also function as a diffusion barrier layer of the first bonding pads 298 and may include, for example, at least one of SiO, SiN, SiCN, SiOC, SiON or SiOCN.

The second substrate structure S2 may include gate electrodes 130 vertically stacked, interlayer insulating layers 120 alternately stacked with the gate electrodes 130, channel structures CH penetrating through or extending into the gate electrodes 130, an upper insulating layer 150 on upper ends of the channel structures CH, a source structure 160 on the upper insulating layer 150, and a cell region insulating layer 290. The second substrate structure S2 may further include studs 170 on lower surfaces of the channel structures CH, bit lines 180 connected to the studs 170, cell contact plugs 182, and cell interconnection lines 184, as second interconnection structures. The second substrate structure S2 may further include second bonding vias 195, second bonding pads 198, and a second bonding insulating layer 199, as second bonding structures.

The gate electrodes 130 may be spaced apart from each other and stacked in a direction that is perpendicular to the upper surface of the substrate 201, for example, in a Z-direction, and may form a gate stack structure including first and second stack structures GS1 and GS2, together with the interlayer insulating layers 120. The first and second stack structures GS1 and GS2 may be vertically stacked and may surround or extend around the first and second channel structures CH1 and CH2, respectively. However, according to example embodiments, the gate stack structure may be formed as a single stack structure or may include three or more stack structures.

The gate electrodes 130 may be sequentially disposed from the source structure 160 and may include lower gate electrodes included in a gate of a ground select transistor, memory gate electrodes included in a plurality of memory cells, and upper gate electrodes included in gates of string select transistors. Here, 'upper' and 'lower' may be referred to based on a state before bonding of the first and second substrate structures S1 and S2. The number of the memory gate electrodes included in the memory cells may be determined according to the capacity of the semiconductor device 100. According to some example embodiments, the number of upper and lower gate electrodes may be one to four or more, respectively, and may have a structure identical to or different from the memory gate electrodes. In example embodiments, the gate electrodes 130 may further include a gate electrode 130 disposed adjacent to the upper gate electrodes and/or the lower gate electrodes and included in an erase transistor used for an erase operation using a gate induced drain leakage (GIDL) phenomenon. Some of the gate electrodes 130, for example, the memory gate electrodes adjacent to the upper gate electrodes and/or the lower gate electrodes, may be dummy gate electrodes.

As illustrated in FIG. 1, the gate electrodes 130 may be disposed to be separated into predetermined units in the Y-direction by separation regions MS. The gate electrodes 130 between a pair of separation regions MS may form a single memory block, but the range of the memory block is not limited thereto.

The gate electrodes 130 may include a metal material, such as tungsten (W). According to some example embodiments, the gate electrodes 130 may include polycrystalline silicon or a metal silicide material. In example embodiments, the gate electrodes 130 may further include a diffusion barrier layer, and may include, for example, tungsten nitride (WN), tantalum nitride (TaN), titanium nitride (TiN), or combinations thereof.

The interlayer insulating layers 120 may be disposed between the gate electrodes 130. The interlayer insulating layers 120 may also be spaced apart from each other in a direction, perpendicular to the upper surface of the substrate 201, and may extend in the X-direction, similar to the gate electrodes 130. The interlayer insulating layers 120 may include a lowermost interlayer insulating layer 120_L, an intermediate interlayer insulating layer 120_M, and an uppermost interlayer insulating layer 120_U, which are disposed on at least one end of the first and second stack structures GS1 and GS2 and have relatively thick thicknesses. However, the relative thicknesses and arrangement positions of the lowermost interlayer insulating layer 120_L, the intermediate interlayer insulating layer 120_M, and the uppermost interlayer insulating layer 120_U, and the other interlayer insulating layers 120 may be variously changed in example embodiments. The interlayer insulating layers 120 may include an insulating material such as silicon oxide or silicon nitride.

Each of the channel structures CH may form one memory cell string and may be spaced apart from each other in rows and columns on a plan view. The channel structures CH may be disposed to form a grid pattern on a plan view or may be arranged in a zigzag shape in one direction. The channel structures CH may have a pillar shape and may have inclined side surfaces so that a width thereof becomes narrower as the channel structures CH approach the source structure 160 depending on the aspect ratio.

Each of the channel structures CH may have a form in which the first and second channel structures CH1 and CH2 penetrating or extending into the first and second stack structures GS1 and GS2 of the gate electrodes 130, respectively, are connected, and may have a bent portion due to a difference or change in width in a connection region. However, according to example embodiments, the number of channel structures stacked in the Z-direction may be variously changed. A portion of the upper surface of each of the channel structures CH may be in contact with the upper insulating layer 150, and another portion of the upper surface may be in contact with a contact region 164 of the source structure 160.

Each of the channel structures CH may include a channel dielectric layer 145, a channel layer 140, and a channel buried insulating layer 147, which are sequentially disposed from the gate electrodes 130 within the channel hole, and may further include a channel pad 149 disposed in a lower end of the channel hole. Between the first channel structure CH1 and the second channel structure CH2, the channel layer 140, the channel dielectric layer 145 and the channel buried insulating layer 147 may be connected to each other.

The channel layer 140 may be formed as an annular shape surrounding or extending around the channel buried insulating layer 147 therein, but may also have a columnar shape such as a cylinder or a prism without the channel buried insulating layer 147 according to some example embodiments. The channel layer 140 may be physically and electrically connected to the source structure 160 through an upper end thereof. The channel layer 140 may include a semiconductor material such as polycrystalline silicon or single-crystal silicon. In some example embodiments, the channel layer 140 may include N-type impurities doped in a region adjacent to the source structure 160. In some example embodiments, the channel layer 140 may have a reduced thickness by partially removing a region adjacent to the source structure 160.

The channel dielectric layer 145 may be disposed on an external side surface of the channel layer 140 and may be disposed between the gate electrodes 130 and the channel layer 140. Although not specifically illustrated, the channel dielectric layer 145 may include a tunneling layer, a charge storage layer, and a blocking layer sequentially stacked from or on the channel layer 140. The tunneling layer may tunnel charges into the charge storage layer and may include, for example, silicon oxide (SiO₂), silicon nitride (Si₃N₄), silicon oxynitride (SiON), or combinations thereof. The charge storage layer may be a charge trap layer or a floating gate conductive layer. The blocking layer may include silicon oxide (SiO₂), silicon nitride (Si₃N₄), silicon oxynitride (SiON), a high-κ dielectric material, or combinations thereof. In example embodiments, at least a portion of the channel dielectric layer 145 may extend along the gate electrodes 130 in a horizontal direction.

The channel pad 149 may be disposed only on a lower end of the second channel structure CH2 on an upper portion. The channel pad 149 may include, for example, doped polycrystalline silicon.

The separation regions MS may extend in the Z-direction through or into the first and second stack structures GS 1 and GS2 and may extend in the X-direction. As illustrated in FIG. 1, the separation regions MS may be disposed to be parallel to each other. The separation regions MS may separate the gate electrodes 130 from each other in the Y-direction. In some example embodiments, the separation regions MS may have curves on side surfaces thereof in the Y-direction in a plan view.

The separation regions MS may have a shape in which a width decreases toward the source structure 160 due to a high aspect ratio. The separation regions MS may have an air-gap or a seam SE therein, but the present disclosure is not limited thereto. The separation regions MS may include an insulating material, and may include, for example, silicon oxide, silicon nitride, or silicon oxynitride.

The upper insulating layer 150 may be disposed on the gate electrodes 130, the channel structures CH, and the uppermost interlayer insulating layer 120_U, and may cover or at least partially overlap upper regions including upper ends of the channel structures CH and upper regions including upper ends of the separation regions MS. The upper insulating layer 150 may cover or overlap portions of side surfaces of the channel structures CH and upper surfaces thereof, and may cover or overlap portions of side surfaces of the separation regions MS and upper surfaces thereof. In example embodiments, a height at which the channel structures CH and the separation regions MS protrude or extend into the upper insulating layer 150 and a thickness of the upper insulating layer 150 according to the height may be variously changed. For example, the height of the channel structures CH protruding or extending into the upper insulating layer 150 may be 1000 Å or more, for example, in a range of about 1000 Å to about 3000 Å, and the thickness of the upper insulating layer 150 may be greater than the protruding or extension height. The upper insulating layer 150 may include an insulating material, and include, for example, silicon oxide, silicon nitride, or silicon oxynitride.

The source structure 160 may be disposed on the upper insulating layer 150, and may include a horizontal region 162 extending horizontally, and contact regions 164 extending downwardly (e.g., in the Z-direction) from the horizontal region 162 toward the channel structures CH and contacting the channel layer 140. The horizontal region 162 may have a rectangular shape in a plan view, and may be disposed, for example, as a single layer on a plurality of memory blocks. The contact regions 164 may have a line or linear shape in the plan view, as illustrated in FIG. 1, and in example embodiments, the contact regions 164 may have a line or linear shape extending in the X-direction. The contact regions 164 may include a plurality of lines arranged at the same pitch as that of rows of the channel structures CH. However, in some example embodiments, the contact regions 164 may have a line shape extending in the Y-direction.

The contact regions 164 may have a trench shape penetrating through or extending into portions of the upper insulating layer 150 and each of the channel structures CH. The contact regions 164 may include trench regions extending in one direction within the upper insulating layer 150. Each of the contact regions 164 may protrude or extend downwardly (e.g., in the Z-direction) from a lower surface of the horizontal region 162. Upper surfaces of the contact regions 164 may be disposed on a higher level in the Z-direction than upper surfaces of the channel structures CH (e.g., a distance between a lower surface of the second substrate structure S2 and the upper surface of the contact region 164 in the Z-direction is greater than distances between the lower surface of the second substrate structure S2 and the upper surfaces of the channel structures CH in the Z-direction). The horizontal region 162 and the contact regions 164 may be integrally formed, but the present disclosure is not limited thereto.

As illustrated in FIG. 3, the contact region 164 may penetrate through or extend into the upper insulating layer 150, and may penetrate through or extend into the channel dielectric layer 145 of the channel structure CH to contact a portion of an upper surface of the channel layer 140 and a portion of an external side surface connected to the upper surface. The contact region 164 may not be in contact with another portion of the upper surface of the channel layer 140 and another portion of the external side surface. In example embodiments, the contact region 164 may not penetrate through or extend into the channel layer 140 and may extend along the external surface of the channel layer 140. Accordingly, the contact region 164 may have a bent shape along the external surface of the channel layer 140, and may have an asymmetrical shape with respect to a central axis thereof. Such a shape may be formed by selectively etching only the channel dielectric layer 145 with respect to the channel layer 140 when forming a contact trench in which the contact region 164 is disposed.

The contact region 164 may be not aligned in a straight line with (e.g., or partially overlap in the Z-direction) the channel structure CH, and may be in contact with the channel layer 140 on one side of the channel structure CH. As an example, the contact region 164 may be disposed to have a central axis CA that is shifted or offset in the X-direction from a central axis CB of the channel structure CH in the Z-direction. Accordingly, the channel structure CH may have an asymmetrical shape with respect to the central axis due to the contact region 164. In some example embodiments, some of the contact regions 164 may be aligned with some of the channel structures CH and some of the contact regions 164 may have a central axis that is shifted or offset in the X-direction from some of the central axes of the channel structures CH. In some example embodiments, at least one channel structure CH may have a central axis that is shifted or offset in the X-direction from the contact region 164 and is connected to the contact region 164 in a form as illustrated in FIG. 3.

A lower end or a lower surface of the contact region 164 may be disposed within the uppermost interlayer insulating layer 120_U. The lower end of the contact region 164 may be spaced apart from the uppermost gate electrode 130 by a first distance D1. The first distance D1 may be, for example, about 50 Å or more when the uppermost gate electrode 130 is a dummy gate electrode, and may be or about 300 Å or more when the uppermost gate electrode 130 is not a dummy gate electrode, but the present disclosure is not limited thereto. The lower surface of the contact region 164 may be in contact with the channel dielectric layer 145 and the uppermost interlayer insulating layer 120_U.

The contact region 164 may have a shape in which a width thereof decreases toward the channel structure CH. A first width W1 of an upper surface of the contact region 164 may be greater than a second width W2 of a lower surface thereof. The first width W1 and the second width W2 may be greater than a thickness of the horizontal region 162, but the present disclosure is not limited thereto. The first width W1 and the second width W2 may be determined within a range in which an intended thickness of the horizontal region 162 may be implemented while the contact region 164 is stably filled when forming the source structure 160. A height of the contact region 164 may be in a range of about 100 nm to about 400 nm, for example, in a range of about 100 nm to about 300 nm, and may be variously changed depending on the thickness of the upper insulating layer 150.

The source structure 160 may include a conductive material, for example, crystalline silicon. However, in some example embodiments, the source structure 160 may include a metal material. The horizontal region 162 and the contact regions 164 may include the same material.

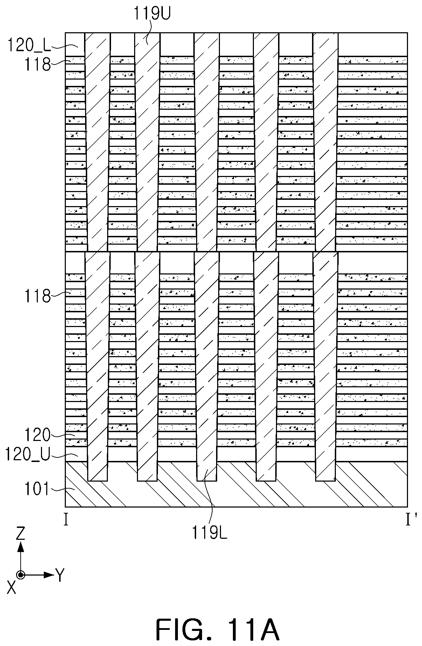

Since the source structure 160 includes contact regions 164 formed by a dry etching process, during the manufacturing process of the semiconductor device 100, defects such as the exposure of the seam SE of the separation region MS or the fracture of the upper ends of the channel structures CH may be prevented or inhibited from occurring, and the process may be easily performed. This will be described in more detail with reference to FIGS. 11A to 11F below.

As illustrated in FIG. 1, upper separation regions US may extend in the X-direction between the separation regions MS adj acent to each other in the Y-direction. The number of upper separation regions US disposed between the adjacent separation regions MS may be variously changed in example embodiments. The upper separation regions US may be disposed to penetrate through or extend into some of the gate electrodes 130, including the lowermost gate electrode 130, among the gate electrodes 130.

The upper separation regions US may, for example, separate a total of three gate electrodes 130 from each other in the Y-direction, as illustrated in FIG. 2. The gate electrodes 130 separated by the upper separation regions US may be, for example, upper gate electrodes included in gates of string select transistors. However, the number of gate electrodes 130 separated by the upper separation regions US may be variously changed in example embodiments. At least some of the upper separation regions US may be disposed to at least partially penetrate through or extend into the channel structures CH. However, in some example embodiments, the upper separation regions US may not penetrate through or extend into the channel structures CH. The upper separation regions US may include an insulating material, and include, for example, silicon oxide, silicon nitride, or silicon oxynitride.

The cell region insulating layer 290 may be disposed to cover or at least partially overlap a lower surface of the second stack structure GS2. The cell region insulating layer 290 may include at least one of an insulating material, and may include, for example, at least one of silicon oxide, silicon nitride, or silicon carbide, and may be formed of a plurality of insulating layers according to example embodiments.

The studs 170, bit lines 180, cell contact plugs 182, and cell interconnection lines 184 may be included in a second interconnection structure electrically connected to memory cells of the second semiconductor structure S2. The studs 170 may be connected to the channel structures CH, and the channel structures CH may be electrically connected to the bit lines 180. The studs 170 may have a plug shape, and the bit lines 180 may have a line or linear shape extending in one direction, for example, the Y-direction. The cell interconnection lines 184 may be electrically connected to the bit lines 180 by the cell contact plugs 182. However, in example embodiments, the number of layers and the arrangement of the contact plugs and the interconnection lines included in the second interconnection structure may be variously changed.

The studs 170, the bit lines 180, the cell contact plugs 182 and the cell interconnection lines 184 may include a metal, and may include, for example, tungsten (W), copper (Cu), or aluminum (Al).

In the second bonding structure, the second bonding vias 195 may be disposed below the cell interconnection lines 184 and may be connected to the cell interconnection lines 184, and the second bonding pads 198 may be connected to the second bonding vias 195. Lower surfaces of the second bonding pads 198 may form a portion of a lower surface of the second substrate structure S2. The second bonding pads 198 may be bonded and connected to the first bonding pads 298 of the first substrate structure S1, and the second bonding insulating layer 199 may be bonded and connected to the first bonding insulating layer 299 of the first substrate structure S1. The second bonding vias 195 and the second bonding pads 198 may include a conductive material, for example, copper (Cu). The second bonding insulating layer 199 may include, for example, at least one of SiO, SiN, SiCN, SiOC, SiON, or SiOCN.

The first and second substrate structures S1 and S2 may be bonded by the bonding of the first bonding pads 298 and the second bonding pads 198 and the bonding of the first bonding insulating layer 299 and the second bonding insulating layer 199. The bonding of the first bonding pads 298 and the second bonding pads 198 may be, for example, copper (Cu)-to-copper (Cu) bonding, and the bonding of the first bonding insulating layer 299 and the second bonding insulating layer 199 may be, for example, dielectric-to-dielectric bonding, such as SiCN-to-SiCN bonding. The first and second substrate structures S1 and S2 may be bonded by hybrid bonding including copper (Cu)-to-copper (Cu) bonding and dielectric-to-dielectric bonding.

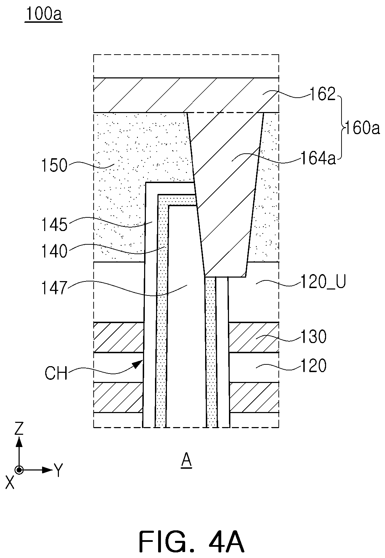

FIGS. 4A to 4C are schematic partial enlarged views of semiconductor devices according to example embodiments. FIGS. 4A to 4C illustrate regions corresponding to FIG. 3.

Referring to FIG. 4A, in a semiconductor device 100a, a contact region 164a of a source structure 160a may penetrate through or extend into the upper insulating layer 150, and may penetrate through or extend into portions of the channel dielectric layer 145, the channel layer 140 and the channel buried insulating layer 147 of the channel structure CH to come into contact with ends in an extension direction of the channel layer 140. Unlike the example embodiment of FIG. 3, the contact region 164a may be disposed to penetrate through or extend into not only the channel dielectric layer 145, but also portions of each of the layers of the channel structure CH. The contact region 164a may be in contact with an end of a region extending horizontally by forming an upper end of the channel layer 140 and an end of a region extending vertically by forming a side portion. A lower surface of the contact region 164a may be in contact with at least the channel layer 140 and the channel dielectric layer 145. The contact region 164a may have a shape symmetrical with respect to the central axis thereof. In some example embodiments, the contact region 164a may have a shape relatively further recessed than the channel buried insulating layer 147.

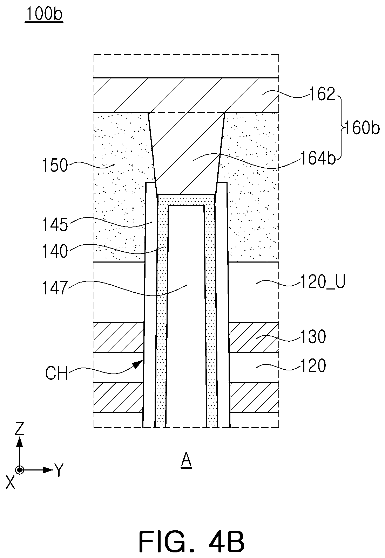

Referring to FIG. 4B, in a semiconductor device 100b, a contact region 164b of a source structure 160b may be aligned in a straight line with (e.g., or at least partially overlap in the Z-direction) the channel structure CH, and may be in contact with an entire upper surface of the channel layer 140 and a portion of an external side surface extending from the upper surface. A central axis of the contact region 164b may coincide with (e.g., overlap) a central axis of the channel structure CH. The contact region 164b may have a line or linear shape extending along centers of the channel structures CH on a plan view. In some example embodiments, the channel structure CH may have a shape symmetrical with respect to the central axis thereof.

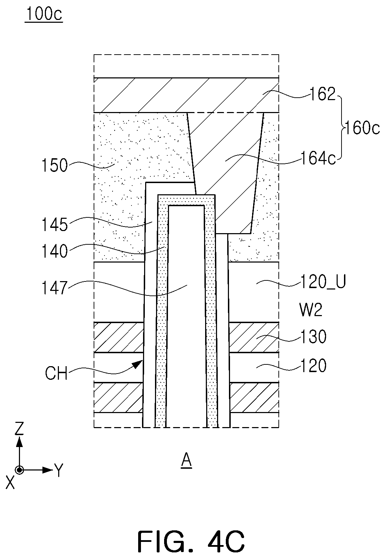

In some example embodiments, when the contact region 164b has a relatively small width, the contact region 164b may only contact the upper surface of the channel layer 140, and when the contact region 164b has a relatively large width, an area in which the contact region 164b is in contact with the external side surface of the channel layer 140 increases and a lower end of the contact region 164b may be lowered. In some example embodiments, the contact region 164b may be disposed to extend into the channel structure CH by penetrating through or extending into portions of the channel dielectric layer 145, the channel layer 140 and the channel buried insulating layer 147 of the channel structure CH, as shown in FIG. 4A. In this manner, in example embodiments below, the contact region is described as having either a structure in which an etching process is performed with a selectivity with respect to the channel layer 140, as in the example embodiment of FIG. 3, or a structure in which an etching process is performed without an etching selectivity, as shown in FIG. 4, but unless otherwise described, the contact region may also have a structure according to other cases.

Referring to FIG. 4C, in a semiconductor device 100c, a lower end or a lower surface of a contact region 164c of a source structure 160c may be disposed within the upper insulating layer 150. For example, when the contact region 164c has a relatively small height or the upper insulating layer 150 has a relatively large thickness, a lower end of the contact region 164c may be disposed within the upper insulating layer 150 as described above.

In example embodiments, the example embodiments of FIGS. 4A to 4C described above may be combined in various manners.

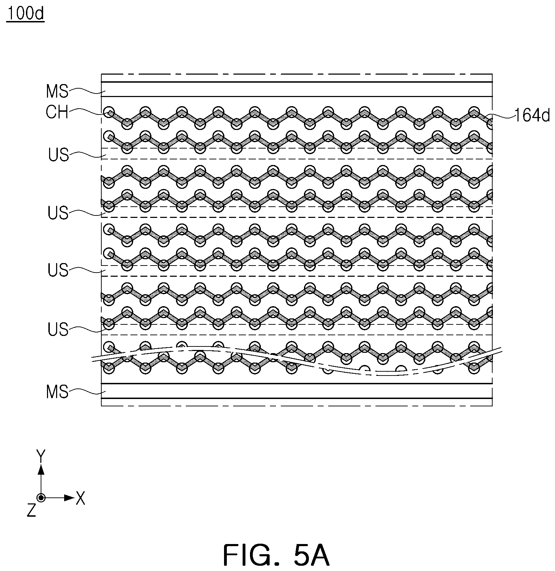

FIGS. 5A to 5D are schematic plan views of semiconductor devices according to example embodiments. FIGS. 5A to 5D illustrate regions corresponding to FIG. 1.

Referring to FIG. 5A, in a semiconductor device 100d, a contact regions 164d of the source structure 160 may have a line or linear shape extending in a zigzag manner in the X-direction. Contact regions 164d may be disposed in a zigzag shape on the channel structures CH of two adjacent rows. However, in some example embodiments, the contact regions 164d may form a zigzag shape on the channel structures CH of three or more rows. In some example embodiments, the contact regions 164d may be disposed in a form shifted or offset from the channel structures CH in one direction, for example, in the Y-direction.

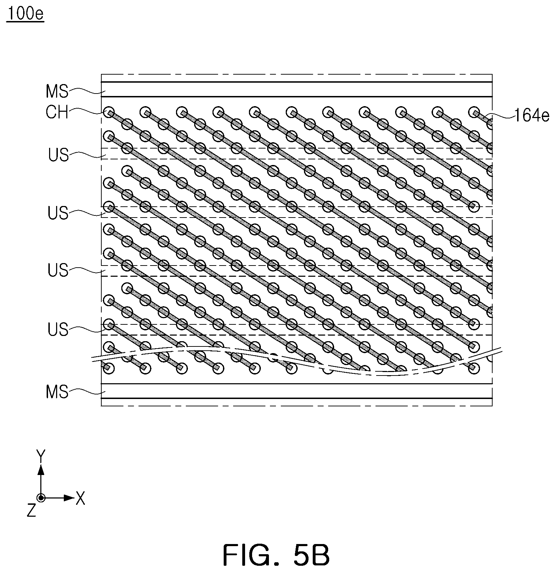

Referring to FIG. 5B, in a semiconductor device 100e, contact regions 164e of the source structure 160 may have a line or linear shape extending in a diagonal direction between the X-direction and the Y-direction. In example embodiments, a length and an extension direction of each line of the contact regions 164e may be variously changed. In some example embodiments, the contact regions 164e may be disposed in a form shifted or offset from the channel structures CH in one direction, for example, in a direction perpendicular to the extension direction.

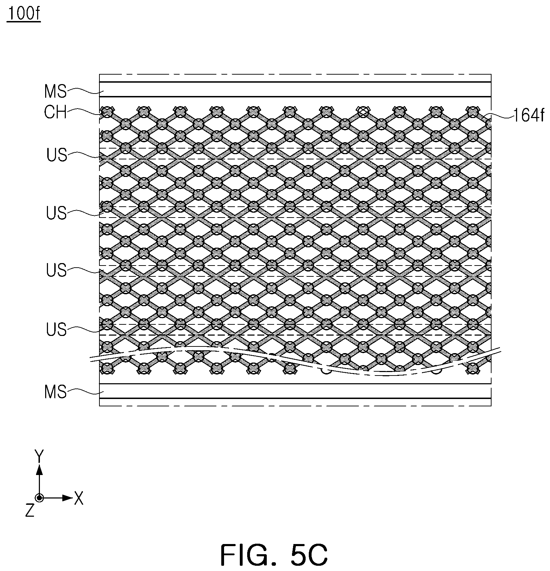

Referring to FIG. 5C, in a semiconductor device 100f, a contact regions 164f of the source structure 160 may have a line or linear shape extending in a diagonal direction between the X-direction and the Y-direction and intersecting each other. The contact regions 164f may be connected to each other in a grid shape or a mesh shape. The contact regions 164f may form a single layer connected to each other, but the present disclosure is not limited thereto. In some example embodiments, the contact regions 164f may have a shape in which lines extending in the X-direction and the Y-direction intersect each other perpendicularly. In some example embodiments, the contact regions 164f may be disposed in a form shifted or offset from the channel structures CH in one direction, for example, in a direction, perpendicular to the extension direction.

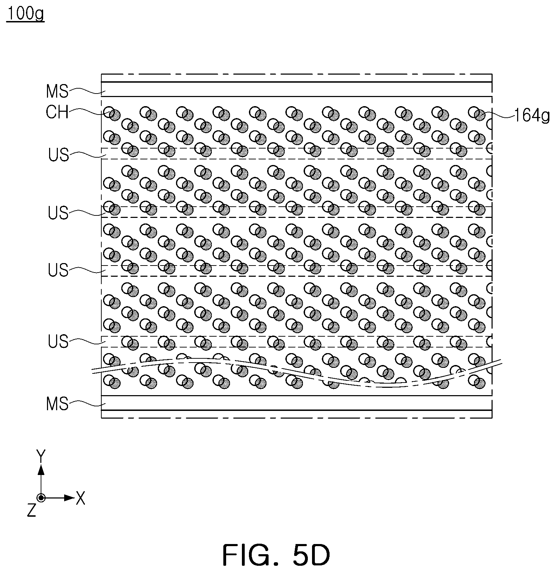

Referring to FIG. 5D, in a semiconductor device 100g, contact regions 164g of the source structure 160 may be disposed in a circular shape on the channel structures CH, respectively. The contact regions 164g may be disposed in a shape shifted or offset from the channel structures CH in one direction, but the present disclosure is not limited thereto. In some example embodiments, the contact regions 164g may have various shapes, such as an oval or a square, in a plan view.

As in the example embodiments of FIGS. 5A to 5D, the contact regions 164d, 164e, 164f and 164g may include regions disposed at the same pitch as those of the rows and/or columns of the channel structures CH, or may be arranged to correspond one-to-one to an arrangement of the channel structures CH.

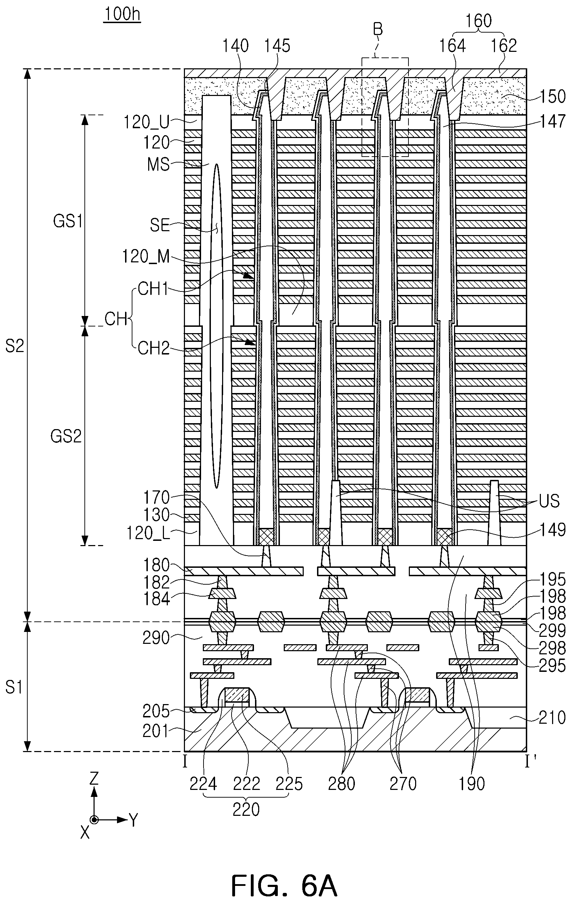

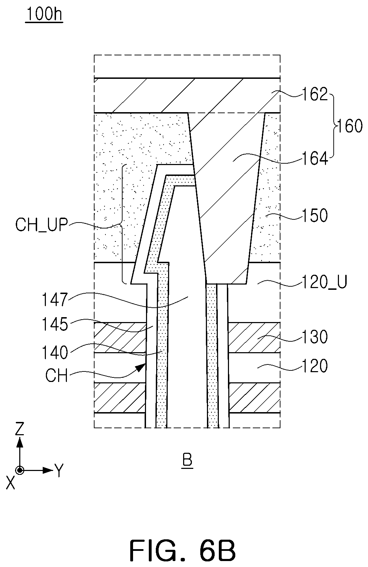

FIGS. 6A and 6B are schematic cross-sectional views and partially enlarged views of semiconductor devices according to example embodiments. FIG. 6A illustrates a region corresponding to FIG. 2, and FIG. 6B illustrates an enlarged view of a region 'B' of FIG. 6A.

Referring to FIGS. 6A and 6B, in a semiconductor device 100h, each of the channel structures CH may include an upper pad portion CH_UP in an upper end. The upper pad portions CH_UP may be a region in which a width thereof discontinuously expands from the upper ends of the channel structures CH and is at least partially overlapped by or covered with an upper insulating layer 150. Accordingly, the channel structures CH may have a bent portion having a shape that is bent along the upper pad portions CH_UP.

The channel dielectric layer 145, the channel layer 140, and the channel buried insulating layer 147 of the channel structure CH may conformally extend into the upper pad portion CH_UP. In some example embodiments, in the upper pad portion CH_UP, a seam may be present within the channel buried insulating layer 147. In some example embodiments, the channel buried insulating layer 147 may not extend into the upper pad portion CH_UP, and an internal region of the upper pad portion CH_UP may be at least partially filled with the channel layer 140. A lower surface of the upper pad portion CH_UP is illustrated as being disposed within the uppermost interlayer insulating layer 120_U, but a level of the lower surface is not limited thereto. In some example embodiments, the lower surface of the upper pad portion CH_UP may be disposed on the same level as a lower surface of the upper insulating layer 150 or may be disposed within the upper insulating layer 150.

As illustrated in FIG. 6B, the contact region 164 of the source structure 160 may penetrate through or extend into a portion of the upper pad portion CH_UP and may extend into the uppermost interlayer insulating layer 120_U. In some example embodiments, the lower end of the contact region 164 may be disposed on a higher level than that of the lower surface of the upper pad portion CH_UP. In some example embodiments, the contact region 164 may penetrate through or extend into only the channel dielectric layer 145 of the upper pad portion CH_UP and may be contact the external surface of the channel layer 140, as in the example embodiment of FIG. 3.

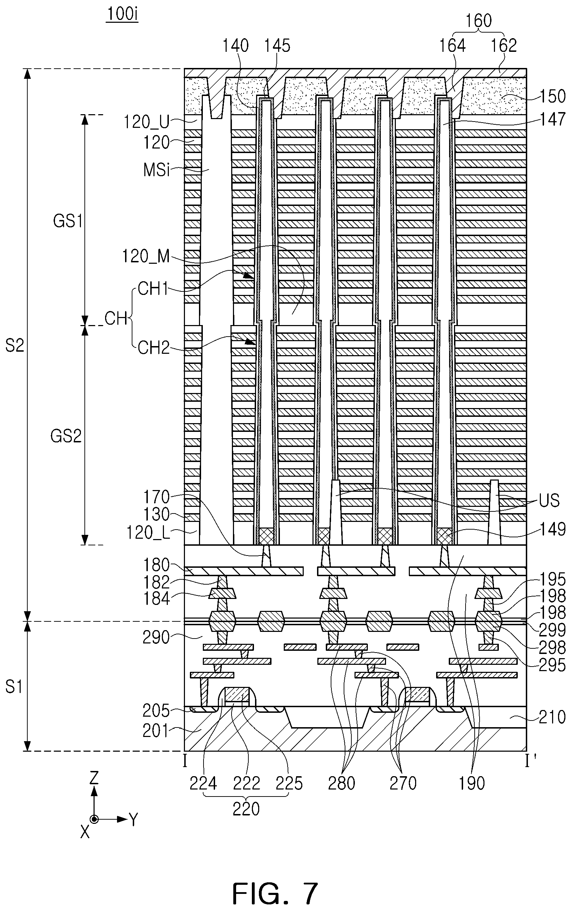

FIG. 7 is a schematic cross-sectional view of a semiconductor device according to example embodiments.

Referring to FIG. 7, in a semiconductor device 100i, at least one of the contact regions 164 of the source structure 160 may be disposed to at least partially overlap a separation region MSi. The contact region 164 may be disposed to partially penetrate through or extend into the separation region MSi from an upper surface of the separation region MSi and at least partially overlap the separation region MSi in the Z-direction. For example, the contact region 164 may extend onto the separation region MSi in the plan view. In some example embodiments, the separation region MSi may not include the seam SE (see FIG. 2) and may include, for example, silicon.

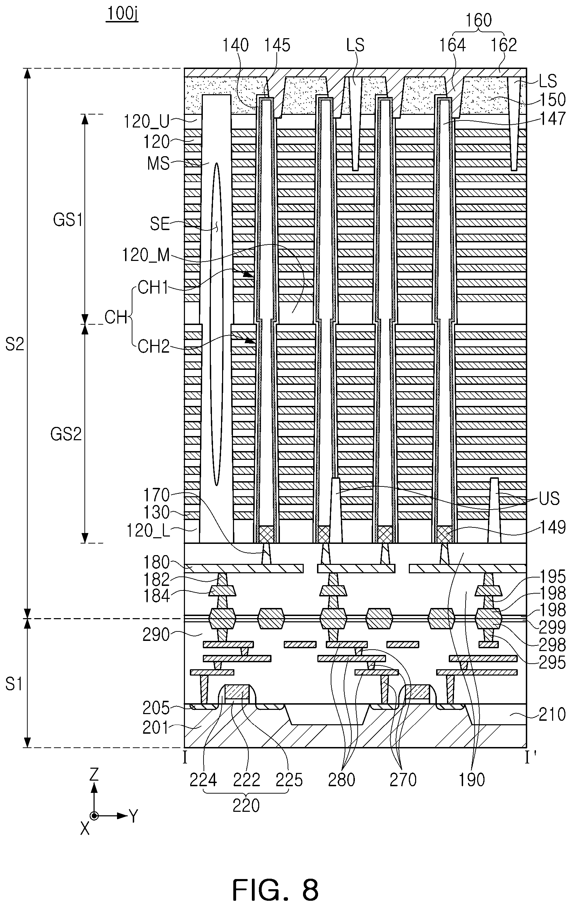

FIG. 8 is a schematic cross-sectional view of a semiconductor device according to example embodiments.

Referring to FIG. 8, a second substrate structure S2 of the semiconductor device 100j may further include lower separation regions LS. The lower separation regions LS may be disposed to penetrate through or extend into gate electrodes 130 including lower gate electrodes, which form a gate of a ground select transistor. The lower separation regions LS may, for example, separate a total of three gate electrodes 130 from each other in the Y-direction. However, the number of gate electrodes 130 separated by the lower separation regions LS may be variously changed in example embodiments. The lower separation regions LS may be disposed in a line or linear shape extending in the X-direction in the plan view. The number of lower separation regions LS disposed between separation regions MS adjacent to each other in the Y-direction may be variously changed in example embodiments.

Each of the lower separation regions LS may have a shape in which a width of an upper surface thereof is greater than a width of a lower surface thereof. The upper surface of the lower separation region LS may be in contact with the lower surface of the horizontal region 162 of the source structure 160. The lower separation region LS may include an insulating material, and may include, for example, silicon oxide, silicon nitride, or silicon oxynitride.

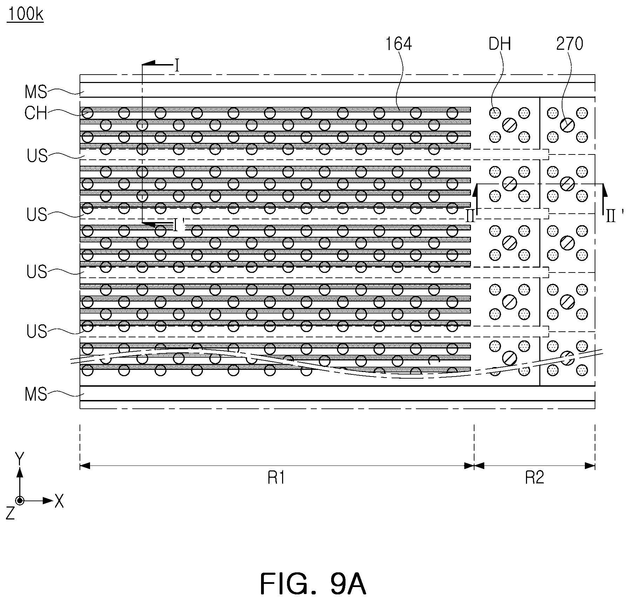

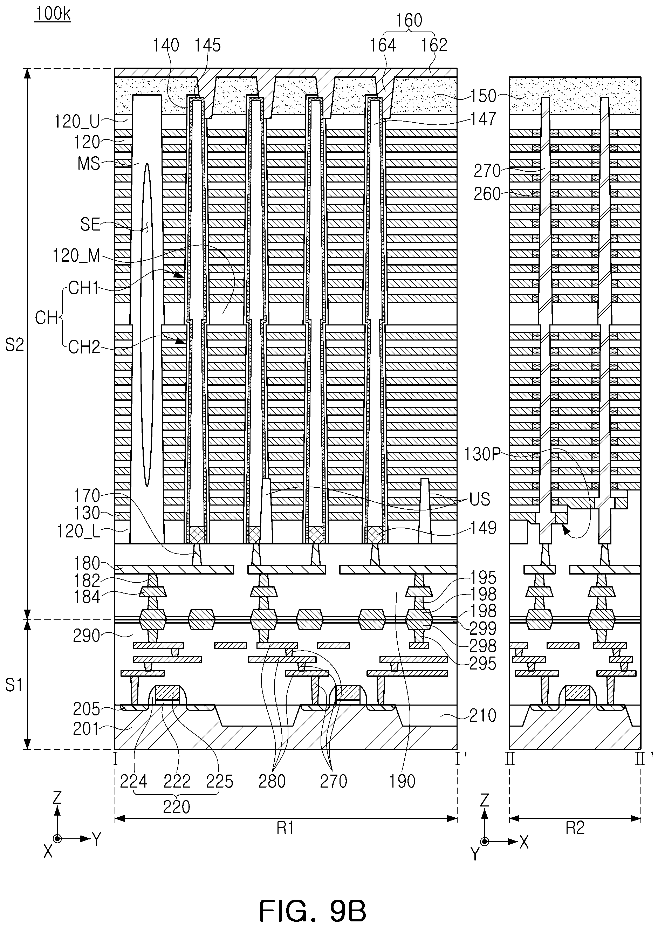

FIGS. 9A and 9B are schematic plan views and cross-sectional views of a semiconductor device according to example embodiments. FIG. 9B illustrates a cross-section along cutting lines I-I' and II-II' of FIG. 9A.

Referring to FIGS. 9A and 9B, in a semiconductor device 100k, the second substrate structure S2 may include a first region R1 and a second region R2. The second substrate structure S2 may further include cell contact plugs 270, dummy vertical structures DH, and contact insulating layers 260 surrounding or extending around side surfaces of the cell contact plugs 270, which are disposed in the second region R2.

The first region R1 may be a region in which the gate electrodes 130 are vertically stacked and the channel structures CH are disposed, and may be a region in which memory cells are disposed. The second region R2 may be a region in which the gate electrodes 130 extend by different lengths and are connected to cell contact plugs 270, and may correspond to a region for electrically connecting the memory cells to the first substrate structure S1. The second region R2 may be disposed at least in one end of the first region R1, at least in one direction, for example, in the X-direction.

In the second region R2, the gate electrodes 130 may be configured so that the upper gate electrode 130 extends to be longer than the lower gate electrode 130, each of which may have end regions 130P in which lower surfaces thereof are exposed downwardly (e.g., in the Z-direction) from the interlayer insulating layers 120. The gate electrodes 130 may be connected to the cell contact plugs 270 in the end regions 130P, respectively. The gate electrodes 130 may have a shape in which a thickness thereof is increased in the end regions 130P.

In some embodiments, the source structure 160 may be disposed only in the first region R1 and may not extend to the second region R2. However, in some example embodiments, the source structure 160 may also extend onto the upper insulating layer 150 of the second region R2. In this case, the contact regions 164 may be spaced apart from the cell contact plugs 270 and may extend between the cell contact plugs 270.

The cell contact plugs 270 may penetrate through or extend into a cell region insulating layer 190 and may be connected to the end regions 130P of the gate electrodes 130, respectively. The cell contact plugs 270 may penetrate through or extend into the gate electrodes 130 on the end regions 130P, and upper ends of the cell contact plugs 270 may be disposed within the upper insulating layer 150. The cell contact plugs 270 may be separated from the gate electrodes 130 on the end regions 130P by the contact insulating layers 260.

The cell contact plugs 270 may have a shape corresponding to the channel structures CH. Each of the cell contact plugs 270 may include regions penetrating through or extending into the first and second stack structures GS1 and GS2, respectively. Each of the regions may have a cylindrical shape in which a width thereof decreases toward the upper insulating layer 150 due to the aspect ratio. Each of the cell contact plugs 270 may have a horizontally expanded shape in the end region 130P.

The upper ends of the cell contact plugs 270 may be covered with or at least partially overlapped by the upper insulating layer 150, and thus, the cell contact plugs 270 may not be exposed and contaminated when the source structure 160 is formed. Additionally, since the upper ends of the cell contact plugs 270 are spaced apart from the source structure 160, the heat generated during a crystallization process for the source structure 160 may be prevented or inhibited from being transferred to the second interconnection structure along the cell contact plugs 270. The cell contact plugs 270 may include a conductive material, and may include, for example, at least one of tungsten (W), copper (Cu), aluminum (Al), or alloys thereof.

The contact insulating layers 260 may be disposed to surround or extend around side surfaces of each of the cell contact plugs 270 on the end regions 130P. The contact insulating layers 260 may be spaced apart from each other in the Z-direction, around each of the cell contact plugs 270. The contact insulating layers 260 may be disposed on substantially the same level as that of the gate electrodes 130, respectively. The contact insulating layers 260 may include an insulating material, and may include, for example, silicon oxide, silicon nitride, or silicon oxynitride.

The dummy vertical structures DH may be spaced apart from each other while forming rows and columns in the second region R2, as illustrated in FIG. 9A. The dummy vertical structures DH may be disposed to surround or extend around each of the cell contact plugs 270 in, for example, four directions. However, an arrangement shape of the dummy vertical structures DH may be variously changed in example embodiments. The dummy vertical structures DH may have a circular shape, an oval shape, or a shape similar thereto in a plan view. The dummy vertical structures DH may have a pillar shape penetrating through or extending into a portion of the gate electrodes 130 and may have inclined side surfaces that become narrower as the gate electrodes 130 approach the upper insulating layer 150 depending on the aspect ratio. The dummy vertical structures DH may include an insulating material. The dummy vertical structures DH may include, for example, silicon oxide, silicon nitride, or silicon oxynitride.

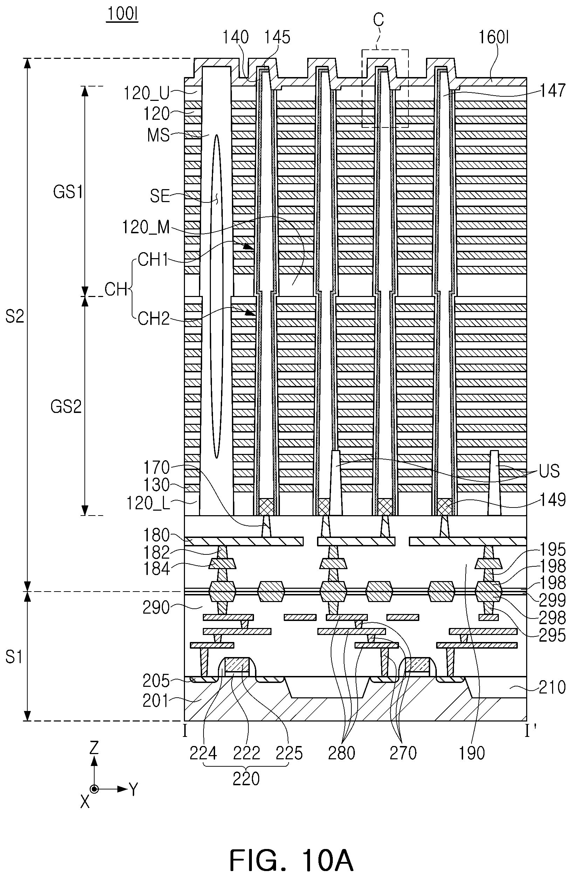

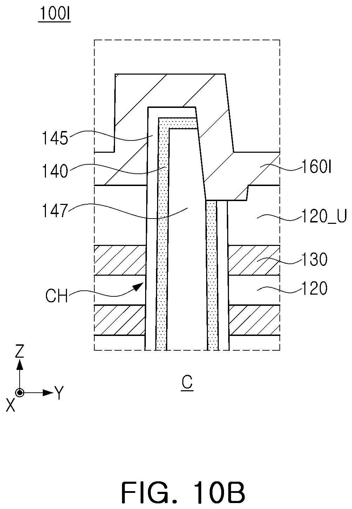

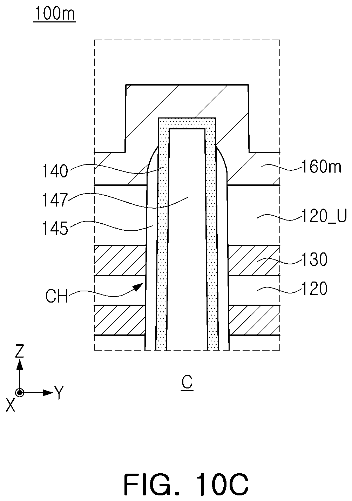

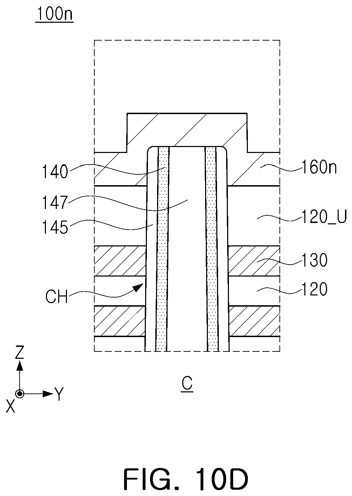

FIGS. 10A to 10D are schematic cross-sectional views and partially enlarged views of a semiconductor device according to example embodiments. FIG. 10A illustrates a region corresponding to FIG. 2, FIG. 10B illustrates an enlarged view of region 'C' of FIG. 10A, and FIGS. 10C and 10D illustrate a region corresponding to FIG. 10B.

Referring to FIGS. 10A and 10B, in a semiconductor device 100l, a source structure 160l may have a form extending along the upper ends of the channel structures CH. The source structure 160l may conformally extend along upper ends of the separation region MS and the upper ends of the channel structures CH as a single layer. The source structure 160l may be in contact with the channel layer 140 in a region from which each of the channel structures CH is partially removed. In some embodiments, the formation of the upper insulating layer 150 (see FIG. 2) may be omitted, and for example, after forming a patterned photoresist layer, a portion of each of the channel structures CH may be removed in a dry etching process, and then the source structure 160l may be formed. In some example embodiments, the source structure 160l may not conformally extend, may have a flat upper surface and may be disposed at a predetermined thickness.

Referring to FIG. 10C, in a semiconductor device 100m, a source structure 160m may have a form extending along an upper end of the channel structure CH, and at least a portion of the channel layer 140 of the channel structure CH on the uppermost interlayer insulating layer 120_U may be at least partially exposed by the channel dielectric layer 145 to come into contact with the source structure 160m. On the uppermost interlayer insulating layer 120_U, the channel dielectric layer 145 may be partially removed and partially remain in the form of a spacer on a side surface of the channel layer 140. However, in example embodiments, the shape of the remaining channel dielectric layer 145 may be variously changed. In some example embodiments, the channel layer 140 may include a region in which a portion thereof is removed from a region exposed from or by the channel dielectric layer 145 so that a thickness thereof is reduced.

In some embodiments, the formation of the upper insulating layer 150 (see FIG. 2) may be omitted, and ends of the channel structures CH may be selectively removed with respect to the channel layer 140 in a dry etching process in a state in which the ends of the channel structures CH are at least partially exposed, and then the source structure 160m may be formed.

Referring to FIG. 10D, in a semiconductor device 100n, a source structure 160n may have a shape extending along the upper end of the channel structure CH, and on the uppermost interlayer insulating layer 120_U, the channel structure CH may have a structure in which the upper end thereof is partially removed and the exposed channel layer 140 contacts the source structure 160n. On the uppermost interlayer insulating layer 120_U, a portion of each of the channel dielectric layer 145, the channel layer 140, and the channel buried insulating layer 147 may be removed. In some example embodiments, the channel buried insulating layer 147 may be further removed than the channel dielectric layer 145 and may have a shape recessed downwardly (e.g., in the Z-direction) from an upper surface thereof.

In some embodiments, the formation of the upper insulating layer 150 (see FIG. 2) may be omitted, and the semiconductor device may be manufactured by removing the ends of the channel structures CH in a dry etching process without a selectivity with respect to the channel layer 140 in a state in which the ends of the channel structures CH are at least partially exposed, and then forming the source structure 160m.

FIGS. 11A to 11F are schematic cross-sectional views illustrating a method of manufacturing a semiconductor device according to example embodiments. FIGS. 11A to 11F each illustrate a region corresponding to FIG. 2.

Referring to FIG. 11A, a manufacturing process of the second substrate structure S2 may begin. First, sacrificial insulating layers 118 and interlayer insulating layers 120 may be alternately stacked on a base substrate 101, and then first and second vertical sacrificial layers 119L and 119U may be formed.

The base substrate 101 is a layer removed through a subsequent process, and may be, for example, a semiconductor substrate such as undoped silicon (Si). The sacrificial insulating layers 118 and the interlayer insulating layers 120 may be alternately stacked on the base substrate 101 to form a lower mold structure. The lower mold structure may be formed at a height at which the first channel structures CH1 (see FIG. 2) are disposed.

First vertical sacrificial layers 119L may be formed to penetrate through or extend into the lower mold structure. The first vertical sacrificial layers 119L may be formed in positions corresponding to the first channel structures CH1 and the separation region MS of FIG. 2. The first vertical sacrificial layers 119L may include, for example, polycrystalline silicon, a carbon-based material, or a metal material.

The upper mold structure may be formed in the same manner on the lower mold structure, and second vertical sacrificial layers 119U may be formed. The second vertical sacrificial layers 119U may be formed to be connected to the first vertical sacrificial layers 119L, respectively.

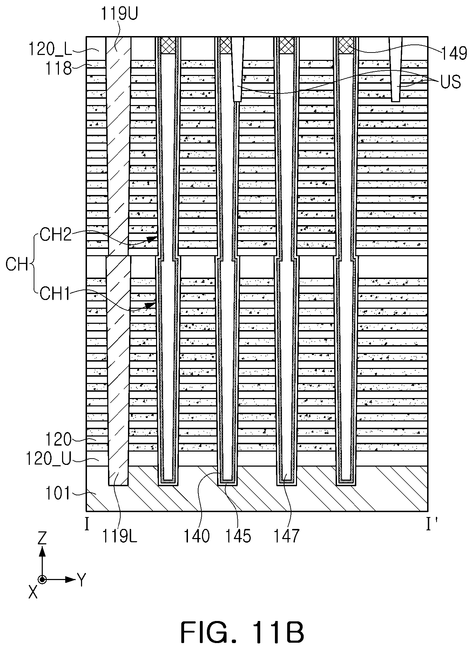

Referring to FIG. 11B, the channel structures CH and the upper separation region US may be formed.

The channel structures CH may be manufactured by removing some of the first and second vertical sacrificial layers 119L and 119U to form channel holes, and then, sequentially depositing a least a portion of the channel dielectric layer 145, the channel layer 140 and the channel buried insulating layer 147 in each of the channel holes, removing some of the channel buried insulating layer 147 from an upper portion and forming a channel pad 149,

The channel dielectric layer 145 may be formed to have a uniform thickness using an atomic layer deposition (ALD) or chemical vapor deposition (CVD) process. The channel dielectric layer 145 may be formed in whole or in part in this operation, and a portion extending vertically (in the Z-direction) to the base substrate 101 along the channel structures CH may be formed in this operation. The channel layer 140 may be formed on the channel dielectric layer 145 in the channel holes. The channel buried insulating layer 147 may be formed to at least partially fill the channel holes and may be formed of an insulating material. The channel pad 149 may be formed of a conductive material, and may be formed of, for example, polycrystalline silicon.

The upper separation region US may be formed by removing a portion of the upper mold structure from an upper surface and depositing an insulating material. The upper separation region US may be formed to at least partially penetrate through or extend into portions of the channel structures CH, but the present disclosure is not limited thereto.

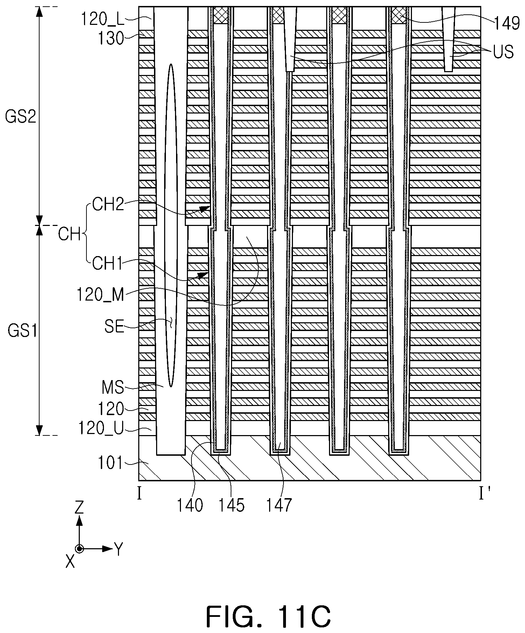

Referring to FIG. 11C, the sacrificial insulating layers 118 may be removed and the gate electrodes 130 may be formed.

The first and second vertical sacrificial layers 119L and 119U may be removed in positions corresponding to the gate separation regions MS of FIG. 1 to form vertical holes. By removing portions of the lower and upper mold structures around the vertical holes, the vertical holes may be expanded to be connected to each other, thereby forming trench-shaped openings corresponding to the separation regions MS.

The sacrificial insulating layers 118 at least partially exposed by or through the openings may be removed. The sacrificial insulating layers 118 may be selectively removed with respect to the interlayer insulating layers 120 and the channel structures CH, for example, using wet etching.

The gate electrodes 130 may be formed by depositing a conductive material in regions from the sacrificial insulating layers 118 are removed. The conductive material may include a metal, polycrystalline silicon, or a metal silicide material. In some example embodiments, a portion of the channel dielectric layer 145 may be formed before forming the gate electrodes 130. Accordingly, a gate stack structure including the first and second stack structures GS1 and GS2 may be formed. After forming the gate electrodes 130, an insulating material may be deposited within the openings to form separation regions MS.

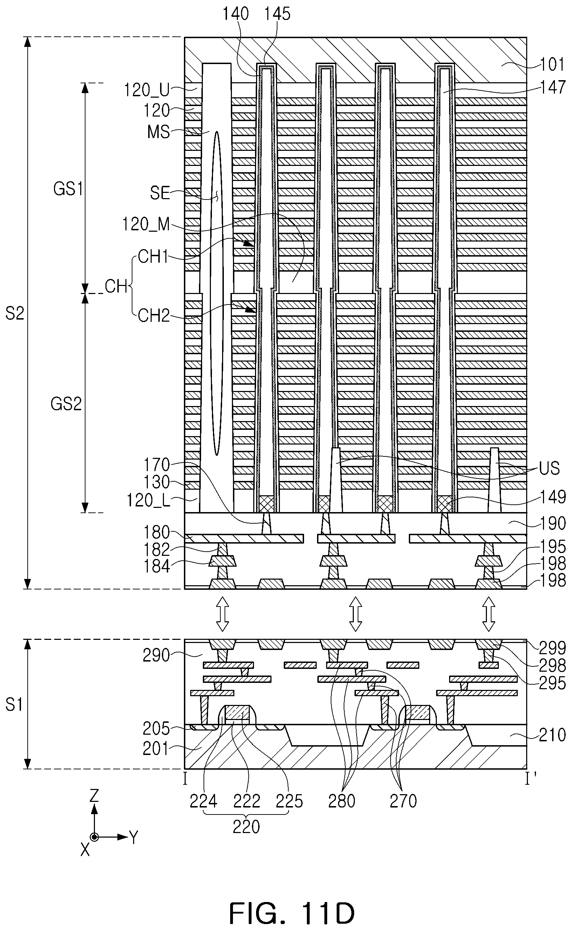

Referring to FIG. 11D, a second interconnection structure and a second bonding structure may be formed on the gate electrodes 130, and the first substrate structure S1 and the second substrate structure S2 may be bonded to each other.

The cell region insulating layer 190 may be formed on the gate electrodes 130 and the channel structures CH, and studs 170, bit lines 180, cell contact plugs 182, and cell interconnection lines 184, included in the second interconnection structure, may be sequentially formed. Second bonding vias 195, second bonding pads 198, and second bonding insulating layers 199, included in the second bonding structure, may be formed on the second interconnection structure. Accordingly, the second substrate structure S2 may be prepared.

The first substrate structure S1 may be prepared by forming circuit elements 220, first interconnection structures, and a first bonding structure on the substrate 201.

Element isolation layers 210 may be formed in the substrate 201, and a circuit gate dielectric layer 222 and a circuit gate electrode 225 may be sequentially formed on the substrate 201. The element isolation layers 210 may be formed, for example, by a shallow trench isolation (STI) process. The circuit gate dielectric layer 222 and the circuit gate electrode 225 may be formed using ALD or CVD. The circuit gate dielectric layer 222 may be formed of silicon oxide, and the circuit gate electrode 225 may be formed of at least one of polycrystalline silicon or a metal silicide layer, but the present disclosure is not limited thereto. Next, a spacer layer 224 and impurity regions 205 may be formed on both sidewalls of the circuit gate dielectric layer 222 and the circuit gate electrode 225. According to example embodiments, the spacer layer 224 may be formed of a plurality of layers. The impurity regions 205 may be formed by performing an ion implantation process.

The circuit contact plugs 270 of the first interconnection structure and the second bonding vias 295 of the first bonding structure may be formed by forming a portion of the peripheral region insulating layer 290, etching and removing a portion thereof, and at least partially filling the removed portion with a conductive material. The circuit interconnection lines 280 of the first interconnection structure and the first bonding pads 298 of the second bonding structure may be formed, for example, by depositing a conductive material and then patterning the conductive material. The second bonding pads 298 may be formed so that upper surfaces thereof are at least partially exposed by or through the second bonding insulating layer 299.

The peripheral region insulating layer 290 may be formed of a plurality of insulating layers. The peripheral region insulating layer 290 may be partially formed in each operation of forming the first interconnection structure and the first bonding structure. By this operation, the first semiconductor structure S1 may be prepared.

Next, the first substrate structure S1 and the second substrate structure S2 may be connected by bonding the first bonding pads 298 and the second bonding pads 198 through annealing and/or pressurization. At the same time, the first bonding insulating layer 299 and the second bonding insulating layer 199 may also be bonded. The second substrate structure S2 may be turned upside down on the first substrate structure S1 so that the second bonding pads 198 face downwardly, and then the bonding may be performed.

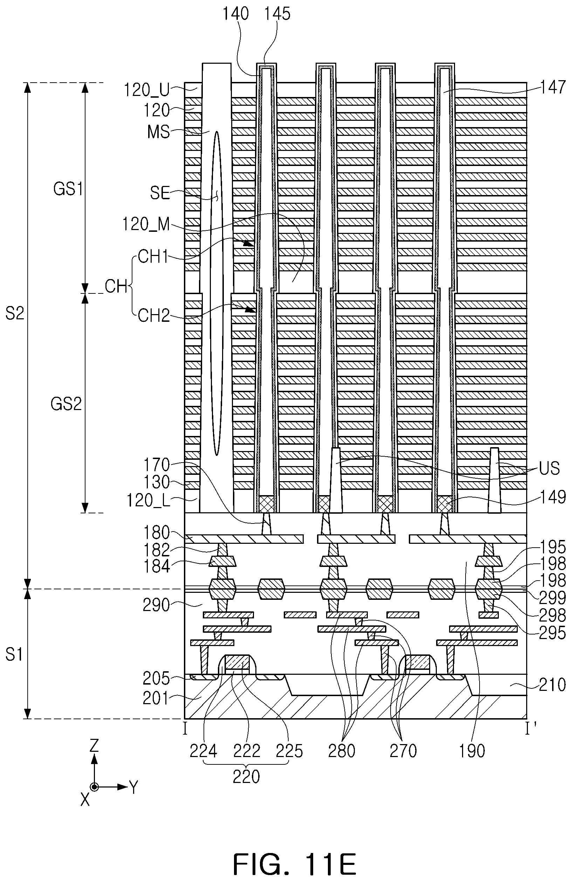

Referring to FIG. 11E, the base substrate 101 may be removed from a bonding structure of the first and second substrate structures S1 and S2.

For example, a portion of the base substrate 101 may be removed from an upper surface by a polishing process such as a grinding process, and the remaining portion thereof may be removed by an etching process such as wet etching. As the base substrate 101 is removed, an upper surface of the uppermost interlayer insulating layer 120_U may be exposed, and upper ends of the channel structures CH and upper ends of the separation region MS may be at least partially exposed.

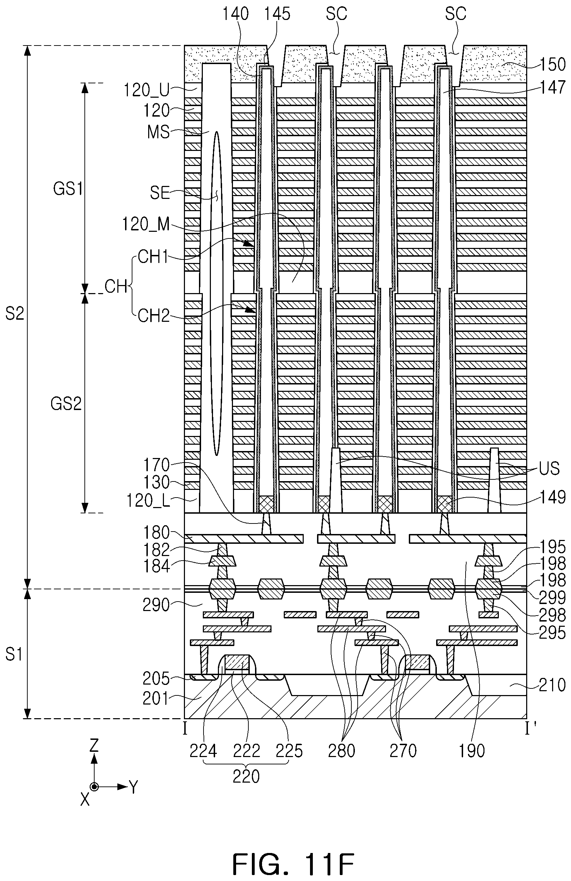

Referring to FIG. 11F, an upper insulating layer 150 may be formed on a bonding structure of the first and second substrate structures S1 and S2, and contact trenches SC may be formed.

The upper insulating layer 150 may be deposited on the uppermost interlayer insulating layer 120_U, and may cover or at least partially the upper ends of the channel structures CH and the upper ends of the separation region MS. The contact trenches SC may be formed by an etching process, for example, a dry etching process. The contact trenches SC may be formed by removing a portion of the upper insulating layer 150 and removing at least a portion of the channel dielectric layer 145 of each of the exposed channel structures CH so that the channel layer 140 is exposed. As an example, the etching process may be performed under the condition having a selectivity for the channel layer 140, and in this case, the channel layer 140 may not be etched and the external surface may be exposed.

In the case of the example embodiments of FIG. 4A, the example embodiments of FIG. 6A and FIG. 6B, the example embodiments of FIG. 10A and FIG. 10B, and the example embodiments of FIG. 10D, in this operation, the etching process may be performed without a selectivity for the channel layer 140, and accordingly, a portion of the channel layer 140 and a portion of the channel buried insulating layer 147 may be further removed. In the case of the example embodiments of FIG. 10A to FIG. 10D, the semiconductor device may be manufactured by performing the etching process while omitting the process of forming the upper insulating layer 150.

Since the contact trenches SC are formed by the dry etching process, an occurrence of defects may be prevented or inhibited and the process may be easily performed, as compared to the comparative example in which only the channel dielectric layer 145 is removed by the wet etching process after the removal of the base substrate 101 from the upper ends of the channel structures CH protruding or extending onto the uppermost interlayer insulating layer 120_U. For example, in the case of the comparative example, during the process, a defect such as the seam SE in the separation regions MS being exposed to fill a material of the source structure 160 into the separation regions MS may occur, but according to example embodiments, such a defect may be prevented or inhibited. In the case of the embodiments of FIGS. 6A and 6B, a defect such as the upper pad portions CH_UP being cut off may occur during the process of the comparative example, but according to example embodiments, such a defect may be prevented. In the case of the embodiments of FIGS. 9A and 9B, during the process of comparative example, the upper ends of the cell contact plugs 270 may be exposed together, and during a subsequent crystallization process for the source structure 160, there may be a problem in which heat is transferred to the second interconnection structure through the cell contact plugs 270, but according to example embodiments, such a problem may be prevented or inhibited.

Next, referring to FIG. 2 together, the source structure 160 may be formed on the upper insulating layer 150.

The source structure 160 may be formed by depositing a conductive material to fill the contact trenches SC and cover an upper surface of the upper insulating layer 150. For example, the source structure 160 may be formed by depositing amorphous silicon (Si) and then performing a crystallization process, for example, by laser annealing. Accordingly, the semiconductor device 100 of FIG. 2 may be manufactured. Additionally, an interconnection structure connected to the source structure 160 may be further formed on the source structure 160.

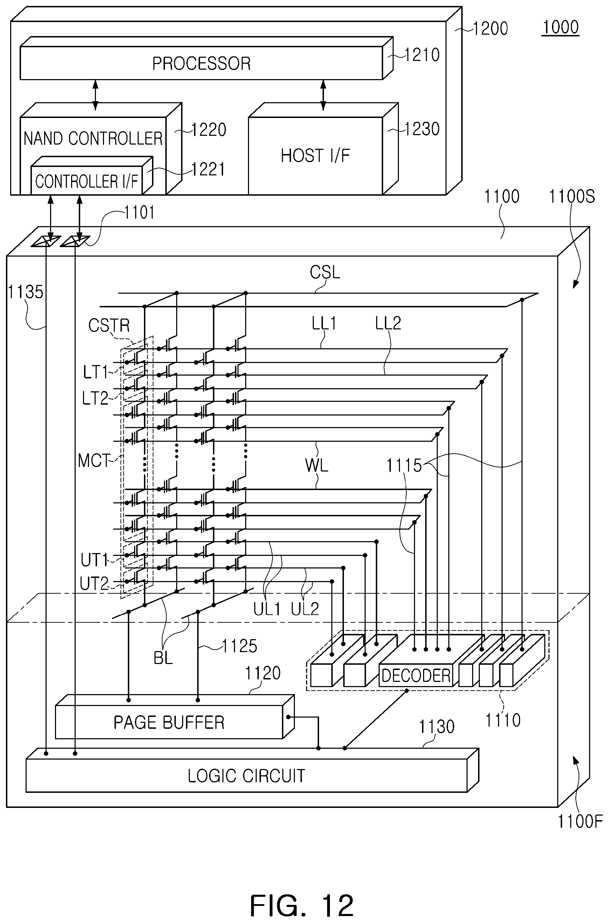

FIG. 12 is a schematic diagram of a data storage system including a semiconductor device according to example embodiments.

Referring to FIG. 12, a data storage system 1000 may include a semiconductor device 1100 and a controller 1200 electrically connected to the semiconductor device 1100. The data storage system 1000 may be a storage device including one or more semiconductor devices 1100 or an electronic device including the storage device. For example, the data storage system 1000 may be a solid state drive device (SSD), a Universal Serial Bus (USB), a computing system, a medical device, or a communication device, including one or more semiconductor devices 1100.

The semiconductor device 1100 may be a nonvolatile memory device, and may be, for example, a NAND flash memory device described above with reference to FIGS. 1 to 10D. The semiconductor device 1100 may include a first structure 1100F and a second structure 1100S on the first structure 1100F. In example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each memory cell string CSTR may include lower transistors LT1 and LT2 adjacent to a common source line CSL, upper transistors UT1 and UT2 adjacent to the bit line BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may be variously changed according to example embodiments.

In example embodiments, the upper transistors UT1 and UT2 may include string select transistors, and the lower transistors LT1 and LT2 may include ground select transistors. The gate lower lines LL1 and LL2 may be gate electrodes of the lower transistors LT1 and LT2, respectively. The word lines WL may be gate electrodes of the memory cell transistors MCT, and the gate upper lines UL1 and UL2 may be gate electrodes of the upper transistors UT1 and UT2, respectively.

In example embodiments, the lower transistors LT1 and LT2 may include a lower erase control transistor LT1 and a ground select transistor LT2 serially connected. The upper transistors UT1 and UT2 may include a string select transistor UT1 and an upper erase control transistor UT2 serially connected. At least one of the lower erase control transistor LT1 and the upper erase control transistor UT2 may be used for an erase operation of erasing data stored in the memory cell transistors MCT by utilizing a GIDL phenomenon.

The common source line CSL, the first and second gate lower lines LL1 and LL2, the word lines WL, and the first and second gate upper lines UL1 and UL2 may be electrically connected to the decoder circuit 1110 through first interconnection lines 1115 extending from the first structure 1100F to the second structure 1100S. The bit lines BL may be electrically connected to the page buffer 1120 through second interconnection lines 1125 extending from the first structure 1100F to the second structure 1100S.

In the first structure 1100F, the decoder circuit 1110 and the page buffer 1120 may perform a control operation for at least one selected memory cell transistor among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output interconnection line 1135 extending from the first structure 1100F to the second structure 1100S.

The controller 1200 may include a processor 1210, a NAND controller 1220, and a host interface 1230. According to example embodiments, the data storage system 1000 may include a plurality of semiconductor devices 1100, and in this case, the controller 1200 may control the plurality of semiconductor devices 1100.

The processor 1210 may control an overall operation of the data storage system 1000 including the controller 1200. The processor 1210 may operate according to a predetermined firmware, and may control the NAND controller 1220 to access the semiconductor device 1100. The NAND controller 1220 may include a NAND interface 1221 processing communication with the semiconductor device 1100. Through the NAND interface 1221, a control command for controlling the semiconductor device 1100, data to be written to the memory cell transistors MCT of the semiconductor device 1100, data to be read from the memory cell transistors MCT of the semiconductor device 1100, and the like, may be transmitted. The host interface 1230 may provide a communication function between the data storage system 1000 and an external host. When receiving a control command from the external host through the host interface 1230, the processor 1210 may control the semiconductor device 1100 in response to the control command.

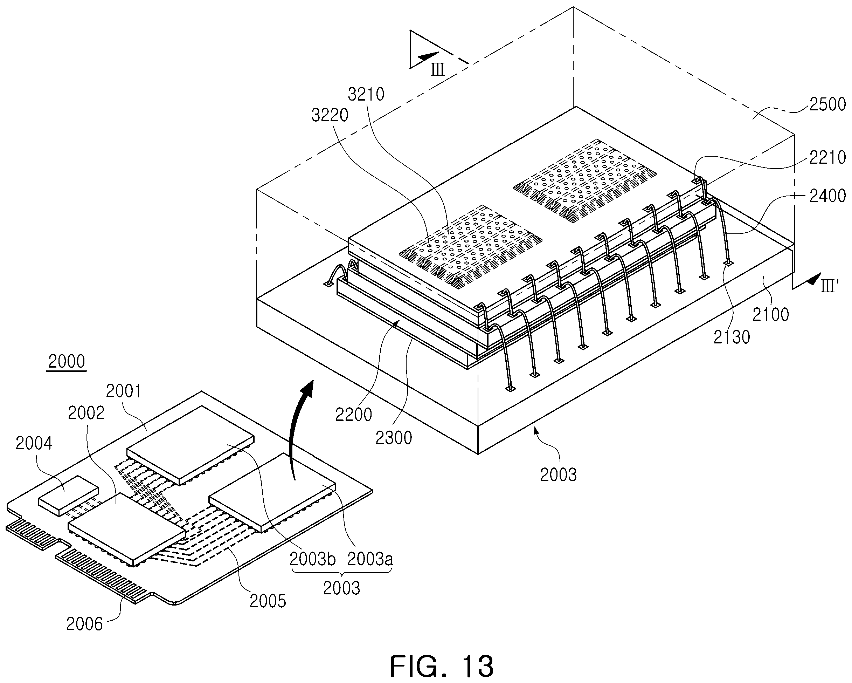

FIG. 13 is a perspective view schematically illustrating a data storage system including a semiconductor device according to some example embodiments.

Referring to FIG. 13, a data storage system 2000 according to some example embodiments of the present disclosure may include a main board 2001, a controller 2002 mounted on the main board 2001, one or more semiconductor packages 2003, and a DRAM 2004. The semiconductor package 2003 and the DRAM 2004 may be connected to each other with the controller 2002 by interconnection patterns 2005 formed on the main board 2001.

The main board 2001 may include a connector 2006 including a plurality of pins coupled to the external host. The number and arrangement of multiple pins in the connector 2006 may be variously changed depending on the communication interface between the data storage system 2000 and the external host. In example embodiments, the data storage system 2000 may communicate with the external host according to any one of the following interfaces: Universal Serial Bus (USB), Peripheral Component Interconnect Express (PCI-Express), Serial Advanced Technology Attachment (SATA), M-Phy for Universal Flash Storage (UFS). In example embodiments, the data storage system 2000 may operate by power supplied from the external host through the connector 2006. The data storage system 2000 may further include a Power Management Integrated Circuit (PMIC) distributing power supplied from the external host to the controller 2002 and the semiconductor package 2003.

The controller 2002 may write data to the semiconductor package 2003 or may read data from the semiconductor package 2003, and may improve the operation speed of the data storage system 2000.

The DRAM 2004 may be a buffer memory to alleviate a speed difference between the semiconductor package 2003, which is a data storage space, and the external host. The DRAM 2004 included in the data storage system 2000 may also operate as a type of cache memory, and may provide a space for temporarily storing data in a control operation for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. Each of the first and second semiconductor packages 2003a and 2003b may be a semiconductor package including a plurality of semiconductor chips 2200. Each of the first and second semiconductor packages 2003a and 2003b may include a package substrate 2100, semiconductor chips 2200 on the package substrate 2100, adhesive layers 2300 disposed on lower surfaces of each of the semiconductor chips 2200, a connection structure 2400 electrically connecting the semiconductor chips 2200 and the package substrate 2100, and a molding layer 2500 covering or at least partially overlapping the semiconductor chips 2200 and the connection structure 2400 on the package substrate 2100.

The package substrate 2100 may be a printed circuit board including package upper pads 2130. Each semiconductor chip 2200 may include an input/output pad 2210. The input/output pad 2210 may correspond to the input/output pad 1101 of FIG. 12. Each of the semiconductor chips 2200 may include gate stack structures 3210 and channel structures 3220. Each of the semiconductor chips 2200 may include the semiconductor device described above with reference to FIGS. 1 to 10D.

In example embodiments, the connection structure 2400 may be a bonding wire electrically connecting the input/output pad 2210 and the package upper pads 2130. Accordingly, in each of the first and second semiconductor packages 2003a and 2003b, the semiconductor chips 2200 may be electrically connected to each other in a bonding wire manner and may be electrically connected to the package upper pads 2130 of the package substrate 2100. According to example embodiments, in each of the first and second semiconductor packages 2003a and 2003b, the semiconductor chips 2200 may be electrically connected to each other by a connection structure including a through-silicon via (TSV), instead of a connection structure 2400 in a bonding wire manner.

In example embodiments, the controller 2002 and the semiconductor chips 2200 may be included in a single package. In some example embodiments, the controller 2002 and the semiconductor chips 2200 may be mounted on a separate interposer substrate different from a main board 2001, and the controller 2002 and the semiconductor chips 2200 may be connected to each other by interconnection lines formed on the interposer substrate.

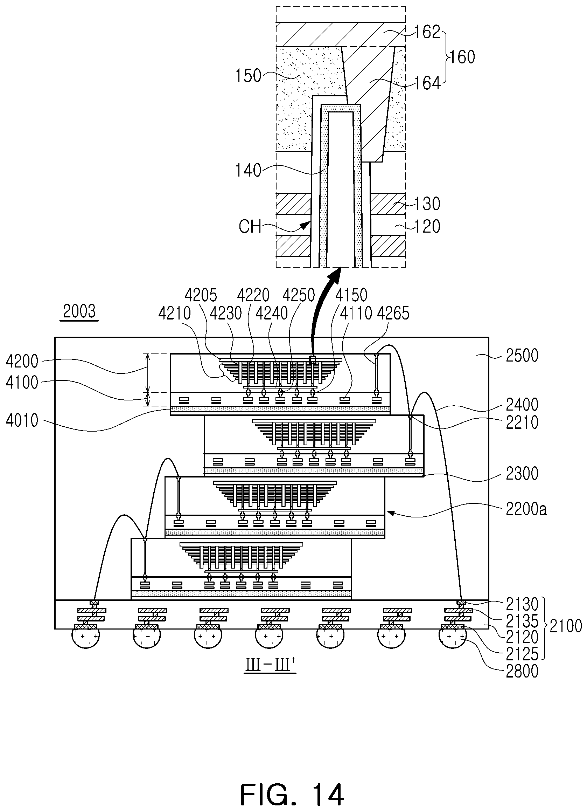

FIG. 14 is a cross-sectional view schematically illustrating a semiconductor package according to some example embodiments. FIG. 14 illustrates some example embodiments of a semiconductor package 2003 of FIG. 13, and conceptually illustrates a region cut along a cutting line III-III' of the semiconductor package 2003 of FIG. 13.

Referring to FIG. 14, in the semiconductor package 2003, the package substrate 2100 may be a printed circuit board. The package substrate 2100 may include a package substrate body 2120, package upper pads 2130 disposed on an upper surface of the package substrate body 2120, lower pads 2125 disposed on a lower surface of the package substrate body 2120 or exposed through the lower surface, and internal interconnection lines 2135 electrically connecting the upper pads 2130 and the lower pads 2125 within the package substrate body 2120. The upper pads 2130 may be electrically connected to the connection structures 2400. The lower pads 2125 may be connected to interconnection patterns 2005 of the main board 2001 of the data storage system 2000 as illustrated in FIG. 13 through conductive connection portions 2800.

Each of the semiconductor chips 2200a may include a semiconductor substrate 4010, a first structure 4100 on the semiconductor substrate 4010, and a second structure 4200 bonded to the first structure 4100 in a wafer bonding manner on the first structure 4100.

The first structure 4100 may include a peripheral circuit region including peripheral interconnection line 4110 and first bonding structures 4150. The second structure 4200 may include a common source line 4205, a gate stack structure 4210, channel structures 4220 and a separation region 4230 penetrating through or extending into the gate stack structure 4210, and second bonding structures 4250 electrically connected to the memory channel structures 4220 and word lines WL of the gate stack structure 4210 (see FIG. 12). For example, the second bonding structures 4250 may be electrically connected to the memory channel structures 4220 and the word lines WL via bit lines 4240 electrically connected to the memory channel structures 4220 and separate cell contact plugs 270 (see FIGS. 9A and 9B) electrically connected to the word lines WL, respectively. The first bonding structures 4150 of the first structure 4100 and the second bonding structures 4250 of the second structure 4200 may be in contact with and bonded to each other. Bonded portions of the first bonding structures 4150 and the second bonding structures 4250 may be formed of, for example, copper (Cu).

The second structure 4200 may include a source structure 160 including a horizontal region 162 and a contact region 164 partially penetrating through or extending into the channel structure CH from the horizontal region 162, as illustrated in the enlarged view. Each of the semiconductor chips 2200a may further include an input/output pad 2210 and an input/output interconnection line 4265 below the input/output pad 2210. The input/output connection wiring 4265 may be electrically connected to some of the second bonding structures 4250.

The semiconductor chips 2200a may be electrically connected to each other by connection structures 2400 in the form of bonding wires. However, in example embodiments, semiconductor chips within a single semiconductor package, such as the semiconductor chips 2200a, may also be electrically connected to each other by connection structures including through-silicon vias (TSVs).

## Claims

1. A semiconductor device (100), comprising:
a first substrate structure (S1) that comprises a substrate (201), circuit elements (220) on the substrate (201), a first interconnection structure on the circuit elements (220), and first bonding pads (298) on the first interconnection structure; and
a second substrate structure (S2) on the first substrate structure (S1),
wherein the second substrate structure (S2) comprises:
gate electrodes (130) that are spaced apart from each other and are stacked in a first direction (Z) that is perpendicular to an upper surface of the substrate (201);
interlayer insulating layers (120) alternately stacked with the gate electrodes (130);
channel structures (CH) that extend into the gate electrodes (130) and in the first direction (Z) and respectively comprise a channel layer (140) and a channel dielectric layer (145) on a side surface of the channel layer (140);
an upper insulating layer (150) that is on upper ends of the channel structures (CH) and the interlayer insulating layers (120);
a source structure (160) on the upper insulating layer (150), the source structure (160) comprising a horizontal region (162) that extends in a second direction (X) that is parallel to the upper surface of the first substrate structure (S1) and a contact region (164) that extends into a portion of the upper insulating layer (150) and each of the channel structures (CH), extends from the horizontal region (162) in the first direction (Z), and contacts the channel layer (140) of each of the channel structures (CH);
a second interconnection structure that is on the gate electrodes (130) and comprises bit lines (180) electrically connected to respective ones of the channel structures (CH); and
second bonding pads (198) that are on the second interconnection structure and are electrically connected to the first bonding pads (298),
wherein a portion of an upper surface of each of the channel structures (CH) is in contact with the upper insulating layer (150).

2. The semiconductor device (100) of claim 1, wherein a width of an upper surface of the contact region (164) in the second direction (X) is greater than a width of a lower surface of the contact region (164) in the second direction (X).

3. The semiconductor device (100) of claim 1 or 2, wherein a central axis (CA) of the contact region (164) is offset from a central axis (CB) of at least one channel structure among the channel structures (CH) in the second direction (X).

4. The semiconductor device (100) of any one of the previous claims, wherein the contact region (164) extends into the channel dielectric layer (145) of a first channel structure (CH1) of the channel structures (CH) and is in contact with a portion of an upper surface of the channel layer (140) of the first channel structure (CH1) and a portion of the side surface of the first channel structure (CH1).

5. The semiconductor device (100) of any one of the previous claims, wherein the contact region (164) extends into the channel layer (140) of a first channel structure (CH1) of the channel structures (CH) and the channel dielectric layer (145) of the first channel structure (CH1) and is in contact with ends of the channel layer (140) of the first channel structure (CH1).

6. The semiconductor device (100) of any one of the previous claims, wherein the contact region (164) comprises a trench region (SC) that extends in the second direction (X) and is in the upper insulating layer (150).

7. The semiconductor device (100) of any one of the previous claims, wherein a lower end of the contact region (164) is in an uppermost interlayer insulating layer among the interlayer insulating layers (120).

8. The semiconductor device (100) of any one of the previous claims, wherein the horizontal region (162) and the contact region (164) comprise a same material.

9. The semiconductor device (100) of any one of the previous claims,
wherein each of the channel structures (CH) comprises a lower portion and an upper pad portion having a different width in the second direction (X) from the lower portion, and
wherein the contact region (164) extends into a portion of the upper pad portion.

10. The semiconductor device (100) of any one of the previous claims,
wherein the second substrate structure (S2) further comprises a lower separation region (LS) extending in the first direction (Z) and the second direction (X) and into an uppermost gate electrode among the gate electrodes (130), and
wherein an upper surface of the lower separation region (LS) is in contact with the horizontal region (162).

11. The semiconductor device (100) of any one of the previous claims,
wherein the second substrate structure (S2) comprises a first region (R1) that comprises the channel structures (CH),
wherein the second substrate structure (S2) comprises a second region (R2) that is on at least one side of the first region (R1) and comprises cell contact plugs (270) that are respectively electrically connected to the gate electrodes (130), and
wherein the source structure (160) is in the first region (R1) and is not on the second region (R2).

12. The semiconductor device (100) of claim 11, wherein the upper insulating layer (150) extends from the first region (R1) to the second region (R2) and at least partially overlaps upper ends of the cell contact plugs (270) in the first direction (Z).

13. The semiconductor device (100) of any one of the previous claims,
wherein the second substrate structure (S2) further comprises a separation region (MS) that extends into the gate electrodes (130) and in the first direction (Z) and the second direction (X), and
wherein the upper insulating layer (150) at least partially overlaps an upper end of the separation region (MS) in the first direction (Z).

14. The semiconductor device (100) of claim 13, wherein the contact region (164) extends into a portion of the separation region (MS).

15. A data storage system (1000, 2000), comprising:
the semiconductor device (100) of any one of the preceding claims, the semiconductor device (100) further comprising input/output pads (1101, 2210) electrically connected to respective ones of the circuit elements (220); and
a controller (1200) electrically connected to the semiconductor device (100) through the input/output pads (1101, 2210).

## Amended claims

### Amended claims in accordance with Rule 137(2) EPC.

1. A semiconductor device (100), comprising:
a first substrate structure (S1) that comprises a substrate (201), circuit elements (220) on the substrate (201), a first interconnection structure on the circuit elements (220), and first bonding pads (298) on the first interconnection structure; and
a second substrate structure (S2) on the first substrate structure (S1),
wherein the second substrate structure (S2) comprises:
gate electrodes (130) that are spaced apart from each other and are stacked in a first direction (Z) that is perpendicular to an upper surface of the substrate (201);
interlayer insulating layers (120) alternately stacked with the gate electrodes (130);
channel structures (CH) that extend into the gate electrodes (130) and in the first direction (Z) and respectively comprise a channel layer (140) and a channel dielectric layer (145) on a side surface of the channel layer (140);
an upper insulating layer (150) that is on upper ends of the channel structures (CH) and the interlayer insulating layers (120);
a source structure (160) on the upper insulating layer (150), the source structure (160) comprising a horizontal region (162) that extends in a second direction (Y) that is parallel to the upper surface of the first substrate structure (S1) and a contact region (164) that extends into a portion of the upper insulating layer (150) and each of the channel structures (CH), extends from the horizontal region (162) in the first direction (Z), and contacts the channel layer (140) of each of the channel structures (CH);
a second interconnection structure that is on the gate electrodes (130) and comprises bit lines (180) electrically connected to respective ones of the channel structures (CH); and
second bonding pads (198) that are on the second interconnection structure and are electrically connected to the first bonding pads (298),
wherein a portion of an upper surface of each of the channel structures (CH) is in contact with the upper insulating layer (150);
wherein a central axis (CA) of the contact region (164) is offset from a central axis (CB) of at least one channel structure among the channel structures (CH) in the second direction (Y).

2. The semiconductor device (100) of claim 1, wherein a width of an upper surface of the contact region (164) in the second direction (Y) is greater than a width of a lower surface of the contact region (164) in the second direction (Y).

3. The semiconductor device (100) of any one of the previous claims, wherein the contact region (164) extends into the channel dielectric layer (145) of a first channel structure (CH1) of the channel structures (CH) and is in contact with a portion of an upper surface of the channel layer (140) of the first channel structure (CH1) and a portion of the side surface of the channel layer (140) of the first channel structure (CH1).

4. The semiconductor device (100) of any one of the previous claims, wherein the contact region (164) extends into the channel layer (140) of a first channel structure (CH1) of the channel structures (CH) and the channel dielectric layer (145) of the first channel structure (CH1) and is in contact with upper ends of the channel layer (140) of the first channel structure (CH1).

5. The semiconductor device (100) of any one of the previous claims, wherein the contact region (164) comprises a trench region (SC) that extends in a third direction (X) that is perpendicular to the second direction (Y) and is in the upper insulating layer (150).

6. The semiconductor device (100) of any one of the previous claims, wherein a lower end of the contact region (164) is in an uppermost interlayer insulating layer among the interlayer insulating layers (120).

7. The semiconductor device (100) of any one of the previous claims, wherein the horizontal region (162) and the contact region (164) comprise a same material.

8. The semiconductor device (100) of any one of the previous claims,
wherein each of the channel structures (CH) comprises a lower portion and an upper pad portion having a different width in the second direction (Y) from the lower portion, and
wherein the contact region (164) extends into a portion of the upper pad portion.

9. The semiconductor device (100) of any one of the previous claims,
wherein the second substrate structure (S2) further comprises a lower separation region (LS) extending in the first direction (Z) and a third direction (X) that is perpendicular to the second direction (Y) and into an uppermost gate electrode among the gate electrodes (130), and
wherein an upper surface of the lower separation region (LS) is in contact with the horizontal region (162).

10. The semiconductor device (100) of any one of the previous claims,
wherein the second substrate structure (S2) comprises a first region (R1) that comprises the channel structures (CH),
wherein the second substrate structure (S2) comprises a second region (R2) that is on at least one side of the first region (R1) and comprises cell contact plugs (270) that are respectively electrically connected to the gate electrodes (130), and
wherein the source structure (160) is in the first region (R1) and is not on the second region (R2).

11. The semiconductor device (100) of claim 10, wherein the upper insulating layer (150) extends from the first region (R1) to the second region (R2) and at least partially overlaps upper ends of the cell contact plugs (270) in the first direction (Z).

12. The semiconductor device (100) of any one of the previous claims,
wherein the second substrate structure (S2) further comprises a separation region (MS) that extends into the gate electrodes (130) and in the first direction (Z) and a third direction (X) that is perpendicular to the second direction (Y), and
wherein the upper insulating layer (150) at least partially overlaps an upper end of the separation region (MS) in the first direction (Z).

13. The semiconductor device (100) of claim 12, wherein the contact region (164) extends into a portion of the separation region (MS).

14. A data storage system (1000, 2000), comprising:
the semiconductor device (100) of any one of the preceding claims, the semiconductor device (100) further comprising input/output pads (1101, 2210) electrically connected to respective ones of the circuit elements (220); and
a controller (1200) electrically connected to the semiconductor device (100) through the input/output pads (1101, 2210).
